(19) Europäisches Patentamt
European Patent Office
Office européen des brevets

(11)     EP 3 667 918 B1

(12)     **EUROPÄISCHE PATENTSCHRIFT**

(45) Veröffentlichungstag und Bekanntmachung des Hinweises auf die Patenterteilung:
**10.07.2024  Patentblatt 2024/28**

(21) Anmeldenummer: **19215088.6**

(22) Anmeldetag: **11.12.2019**

(51) Internationale Patentklassifikation (IPC):
**H03K 17/955** (2006.01)     **E05F 15/73** (2015.01)

(52) Gemeinsame Patentklassifikation (CPC):
**H03K 17/955; E05F 15/73;** E05F 15/46;
E05Y 2400/852; E05Y 2900/50; H03K 2217/960725

(54) **ANORDNUNG FÜR EIN FAHRZEUG**

ASSEMBLY FOR A VEHICLE

AGENCEMENT POUR UN VÉHICULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.12.2018   DE 102018131861**

(43) Veröffentlichungstag der Anmeldung:
**17.06.2020   Patentblatt 2020/25**

(73) Patentinhaber: **Huf Hülsbeck & Fürst GmbH & Co. KG**
**42551 Velbert (DE)**

(72) Erfinder:
• **SIEG, Berthold**
**46240 Bottrop (DE)**
• **STAHL, Daniel**
**31515 Wunstorf (DE)**

(74) Vertreter: **Bals & Vogel Patentanwälte PartGmbB**
**Konrad-Zuse-Str. 4**
**44801 Bochum (DE)**

(56) Entgegenhaltungen:
EP-A2- 1 848 111     WO-A1-2009/007500
US-B2- 9 587 964

## Beschreibung

Die vorliegende Erfindung betrifft eine Messwerterfassungsanordnung für ein Fahrzeug zur Detektion einer Aktivierungshandlung für die Aktivierung einer Funktion am Fahrzeug. Ferner bezieht sich die Erfindung auf ein System sowie ein Verfahren.

Es ist aus dem Stand der Technik bekannt, dass mittels eines Sensorelements, wie einer Sensorelektrode, eine veränderliche Kapazität bereitgestellt werden kann, welche für Veränderungen in der Umgebung des Sensorelements spezifisch ist. Dies ermöglicht es, Änderungen in der Umgebung kapazitiv zu erfassen. Bei Fahrzeugen kann eine derartige kapazitive Erfassung genutzt werden, um Annäherungen und/oder Gesten zu detektieren, und damit Funktionen am Fahrzeug zu aktivieren.

Die kapazitive Erfassung basiert häufig darauf, dass das Sensorelement mittels einer Ladungsübertragung ausgewertet wird. Entsprechend kann es für die Sensorauswertung notwendig sein, eine Spannung und/oder einen Ladezustand zur Auswertung der Ladungsübertragungen zu ermitteln.

Allerdings ist eine solche Sensorauswertung häufig noch technisch aufwendig oder nur mit begrenzter Genauigkeit und Zuverlässigkeit möglich.

Eine Messwerterfassungsanordnung nach dem Oberbegriff des Anspruchs 1 ist im Dokument US 9,587,964 B2 offenbart. Es ist daher eine Aufgabe der vorliegenden Erfindung, die voranstehend beschriebenen Nachteile zumindest teilweise zu beheben. Insbesondere ist es Aufgabe der vorliegenden Erfindung, eine verbesserte kapazitive Erfassung bereitzustellen.

Die voranstehende Aufgabe wird gelöst durch eine Messwerterfassungsanordnung mit den Merkmalen des unabhängigen Vorrichtungsanspruchs 1, ein System mit den Merkmalen des Systemanspruchs 11 sowie durch ein Verfahren mit den Merkmalen des unabhängigen Verfahrensanspruchs 12. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Messwerterfassungsanordnung beschrieben sind, selbstverständlich auch im Zusammenhang mit dem erfindungsgemäßen System sowie dem erfindungsgemäßen Verfahren, und jeweils umgekehrt, sodass bezüglich der Offenbarung zu den einzelnen Erfindungsaspekten stets wechselseitig Bezug genommen wird bzw. werden kann.

Die Aufgabe wird insbesondere gelöst durch eine Messwerterfassungsanordnung für ein Fahrzeug zur Detektion einer Aktivierungshandlung für die Aktivierung einer Funktion am Fahrzeug. Die Aktivierung der Funktion kann z. B. die Aktivierung einer Klappe sein, wie einer Heck- und/oder Front- und/oder Seitenklappe, wobei die Seitenklappe auch eine Schiebetür des Fahrzeuges sein kann.

Hierbei ist insbesondere vorgesehen, dass die Aktivierungshandlung in einem Front-, Seiten- und/oder Heckbereich des Fahrzeuges durchgeführt wird, um bei der Detektion der Aktivierungshandlung die Aktivierung der Funktion in der Form einer Aktivierung, vorzugsweise Öffnung und/oder Entriegelung, einer Klappe am Fahrzeug zu initiieren.

Eine erfindungsgemäße Messwerterfassungsanordnung kann dabei zumindest die nachfolgenden Komponenten aufweisen, welche insbesondere mit einer Leiterplatte der Messwerterfassungsanordnung verbunden sind:

- wenigstens ein (insbesondere elektrisch leitendes) Sensorelement zur Erfassung einer Veränderung, insbesondere einer Annäherung durch ein Aktivierungsmittel, in einer Umgebung des Sensorelements,
- eine Kontrollvorrichtung zur Ermittlung wenigstens eines für die Erfassung spezifischen Parameters des Sensorelements, um die Detektion der Aktivierungshandlung durchzuführen,
- eine elektrische Speicheranordnung, welche zur (wenigstens einen) Ladungsübertragung mit dem wenigstens einen Sensorelement verschaltet ist, wobei die (wenigstens eine) Ladungsübertragung für den Parameter des Sensorelements spezifisch ist.

Hierbei ist vorgesehen, dass die Kontrollvorrichtung eine Zählereinheit aufweist, welche mit der Speicheranordnung verschaltet ist, um einen Ladezustand der Speicheranordnung zeitlich auszuwerten, also eine zeitliche Auswertung des Ladezustands durchzuführen. Hierbei ist insbesondere ein Erfindungsgedanke, dass die zeitliche Auswertung eine verbesserte Auflösung bieten kann als herkömmliche Methoden, welche bei einer derartigen (kapazitiven) Sensorik eingesetzt werden. Auf diese Weise kann besonders genau und/oder mit hoher Auflösung der Ladezustand der Speicheranordnung erfasst werden. Dies ermöglicht wiederum zuverlässig Rückschlüsse auf die Ladungsübertragung zu ziehen, welche insbesondere zur Aufladung der Speicheranordnung genutzt wird. Die Ladungsübertragung kann dabei abhängig sein von dem Parameter, insbesondere von einer Sensorkapazität des Sensorelements. Somit ist es möglich, dass anhand der zeitlichen Auswertung und insbesondere Messung des Ladezustands der Speicheranordnung eine Veränderung des Parameters und damit auch eine Veränderung in der Umgebung des Sensorelements erkennbar ist.

Die Detektion der Aktivierungshandlung kann folglich durch die Nutzung der zeitlichen Auswertung mit besonders hoher Genauigkeit und Zuverlässigkeit bereitgestellt werden. Hierbei kann der Vorteil der zeitlichen Auswertung genutzt werden, dass eine höhere Auflösung erzielt werden kann, als dies bei herkömmlichen Methoden und vergleichbarem technischen Aufwand möglich ist. Insbesondere die Messung des Ladezustands der Speicheranordnung durch eine Analog-Digital-Wandlung eines Mikrocontrollers ist durch die maximale Auflösung des hierbei eingesetzten Analog-Digital-Wandlers des Mikrocontrollers begrenzt. Die zeitliche Auswertung kann diese begrenzte Auflösung verbessern.

Die zeitliche Auswertung kann zur besonders genauen Erfassung des Ladezustands der Speicheranordnung dienen. Hierzu kann z. B. eine elektrische Spannung (welche für den Ladezustand spezifisch ist) über einen Speicherkondensator der Speicheranordnung gemessen werden, indem diese elektrische Spannung in eine Zeitgröße umgewandelt wird. Hierzu kann bspw. die Spannung am Speicherkondensator (Ladekondensator) entladen werden, vorzugsweise über eine Kompensationsanordnung entladen werden, bevorzugt initiiert durch eine Initiierungseinheit. Während dieses Entladens wird die Spannung in der Form eines Auswertesignals bereitgestellt. Die Zeitdauer, die dann benötigt wird, bis die Spannung eine Referenzspannung unterschreitet, kann der Messwerterfassung entsprechen. Um dieses Verfahren weiter zu verbessern, und insbesondere die Entladezeitdauer zu verkürzen, kann ein Analog-Digital-Wandler initial zunächst ein Referenzsignal (insbesondere die Referenzspannung) bereitstellen. Hierzu kann der Analog-Digital-Wandler die Spannung am Speicherkondensator zunächst initial (grob) erfassen und daraus das Referenzsignal und insbesondere eine Referenzspannung bilden. Eine elektronische Zählereinheit kann dann die Anzahl an Zeitsamples zählen, die nötig sind, bis eine Vergleichseinheit (wie ein Komparator) kippt. Die Vergleichseinheit vergleicht dabei das Auswertesignal mit dem Referenzsignal. Das Kippen der Vergleichseinheit erfolgt entsprechend, wenn die Spannung am Speicherkondensator die initial erfasste Referenzspannung unterschreitet.

Es ist ferner denkbar, dass das Referenzsignal, insbesondere die Referenzspannung, für verschiedene zeitliche Auswertungen und/oder verschiedene Ermittlungen des Parameters des Sensorelements sich verändert, und somit veränderlich bzw. variabel ist. Entsprechend kann es vorteilhaft sein, wenn die zeitliche Auswertung eine digitale Verarbeitung umfasst. Auch ist es vorteilhaft, wenn das Referenzsignal bei jeder zeitlichen Auswertung neu erzeugt wird.

Unter Einsatz der zeitlichen Auswertung kann vorteilhafterweise eine verbesserte Auflösung zur Ermittlung des Ladezustands bereitgestellt werden, welche insbesondere abhängig ist von einem Verhältnis der Versorgungsspannung zur Steigung der Entladekurve und/oder einer Zählerabtastfrequenz der Zählereinheit und/oder einer effektiven Auflösung des Analog-Digital-Wandler. Die effektive Auflösung des Analog-Digital-Wandlers in Volt der gemessenen Spannung am Speicherkondensator kann sich dabei ergeben aus der Versorgungsspannung multipliziert mit $2^{-n}$, wobei n die Auflösung in Bit ist. Die Zählerabtastfrequenz kann linear die Auflösung erhöhen. Dabei ist die Zählereinheit vorzugsweise dazu ausgeführt, linear abzutasten.

Die Messwerterfassungsanordnung kann z. B. als eine elektronische Schaltungsanordnung ausgeführt sein, welche zumindest teilweise an einer Leiterplatte angeordnet ist. Die Kontrollvorrichtung ist vorteilhafterweise als ein integrierter Schaltkreis, vorzugsweise als ein Mikrocontroller, ausgebildet, sodass die Zählereinheit Teil dieses Schaltkreises ist. Alternativ kann die Kontrollvorrichtung auch als eine Schaltungsanordnung ausgeführt sein, welche die Zählereinheit als ein von einem Mikrocontroller separates elektronisches Bauelement aufweist.

Ebenfalls unter Schutz gestellt ist eine erfindungsgemäße Anordnung für ein Fahrzeug, welche eine erfindungsgemäße Messwerterfassungsanordnung aufweist. Die erfindungsgemäße Anordnung kann neben den Teilen der Messwerterfassungsanordnung (wie einer Kontrollvorrichtung) noch weitere Teile aufweisen, wie z. B. eine Kompensationsanordnung und/oder eine Sensorkontrollanordnung und/oder eine Filteranordnung. Die erfindungsgemäße Anordnung dient insbesondere dazu, eine Ansteuerung des Sensorelements und/oder die Ladungsübertragung zur Speicheranordnung bereitzustellen. Dagegen kann die Messwerterfassungsanordnung primär zur elektronischen bzw. digitalen Auswertung bei der erfindungsgemäßen Anordnung dienen.

Vorteilhaft ist es zudem, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semiautonomes oder autonomes Fahrzeug ausgebildet ist. Vorteilhafterweise weist das Fahrzeug ein Sicherheitssystem auf, welches z. B. durch eine Kommunikation mit einem Identifikationsgeber (ID-Geber) eine Authentifizierung ermöglicht. In Abhängigkeit von der Kommunikation und/oder der Authentifizierung kann wenigstens eine Funktion des Fahrzeuges aktiviert werden. Falls hierzu die Authentifizierung des ID-Gebers notwendig ist, kann es sich bei der Funktion um eine sicherheitsrelevante Funktion handeln, wie ein Entriegeln des Fahrzeuges und/oder eine Freigabe eines Motorstarts. Somit kann das Sicherheitssystem auch als ein passives Zugangssystem ausgebildet sein, welches ohne aktive manuelle Betätigung des ID-Gebers die Authentifizierung und/oder die Aktivierung der Funktion bei Detektion der Annäherung des ID-Gebers an das Fahrzeug initiiert. Hierzu wird bspw. wiederholt ein Wecksignal durch das Sicherheitssystem ausgesendet, welches durch den ID-Geber bei der Annäherung empfangen werden kann, und dann die Authentifizierung auslöst. Auch kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Annäherung die Fahrzeugbeleuchtung aktiviert und/oder bei der Detektion einer Geste eines Benutzers die Klappe betätigt. Eine Klappe kann dabei insbesondere in der Form einer Tür des Fahrzeuges ausgebildet sein.

Es ist ferner denkbar, dass - für die Aktivierung der Funktion am Fahrzeug - durch eine erfindungsgemäße Anordnung eine Aktivierungshandlung detektiert wird. Es kann sich hierbei insbesondere um eine Aktivierungshandlung außerhalb des Fahrzeuges handeln (welche also nicht im Fahrzeuginnenraum stattfindet). In anderen Worten kann die Umgebung des Sensorelements, in welcher die Veränderung erfasst wird, sich außerhalb des Fahrzeuges befinden. Bei erfolgreicher Detektion der Aktivierungshandlung durch die erfindungsgemäße Anordnung kann dabei durch die Anordnung (insbesondere durch eine Kontrollvorrichtung) die Funktion ausgelöst und/oder die Authentifizierung initiiert werden. Bei der Aktivierungshandlung kann es sich z. B. um die Annäherung und/oder die Geste handeln, welche mittels des Aktivierungsmittels durchgeführt wird. Das Aktivierungsmittel bzw. die Aktivierungshandlung kann vorteilhafterweise auch dann detektiert werden, wenn es sich bei dem Aktivierungsmittel um ein nicht-elektronisches Objekt (und damit auch nicht um einen ID-Geber) handelt. Stattdessen kann das Aktivierungsmittel als eine nichtelektrische und/oder nicht-metallische und/oder biologische Substanz ausgeführt sein, wie z. B. ein Körperteil eines Benutzers. Daher ist die Nutzung einer kapazitiven Erfassung zur Detektion der Aktivierungshandlung besonders vorteilhaft, da dies keine besonderen Vorkehrungen am Aktivierungsmittel voraussetzt.

Eine erfindungsgemäße Anordnung ist vorteilhafterweise als eine elektronische Schaltung (Schaltungsanordnung) ausgebildet, und weist elektronische Komponenten auf, welche zumindest teilweise an einer Leiterplatte angeordnet und über elektrische Leiterbahnen miteinander verschaltet sein können. Wenigstens eine dieser Komponenten kann dabei auch als integrierter Schaltkreis ausgebildet sein (wie z. B. eine Kontrollvorrichtung in der Form eines Mikrocontrollers). Auch können einige der Komponenten als SMD (Surface-Mounted-Device) Bauelemente ausgebildet sein. Das Sensorelement kann elektrisch leitend z. B. als Leiterbahn oder als flächige Elektrode an der Leiterplatte ausgebildet sein, oder auch über eine Zuleitung (wie eine elektrische Leitung) mit der Leiterplatte verbunden sein. Im letzteren Fall ist das Sensorelement bspw. Teil eines Kabels (wie eines Koaxialkabels), als eine flächige Elektrode oder als langgestreckter Leiter ausgebildet. Das Sensorelement kann dabei auch als eine kapazitive Antenne aufgefasst werden, da durch das Sensorelement eine veränderliche Sensorkapazität bereitgestellt wird. Ferner kann die veränderliche Sensorkapazität optional auch durch mehrere Sensorelemente bereitgestellt werden, welche gleichzeitig oder abwechselnd betrieben werden. Die Leiterplatte und/oder das Sensorelement ist z. B. in einem Türgriff oder in einem Stoßfänger integriert. Das Sensorelement kann dabei derart angeordnet sein, dass die Anordnung des Sensorelements einen Detektionsbereich für die Aktivierungshandlung definiert.

Es ist bei einer erfindungsgemäßen Anordnung möglich, dass das Sensorelement als eine Sensorelektrode ausgebildet ist, um den für die Erfassung spezifischen Parameter als eine veränderliche Kapazität (auch Sensorkapazität bezeichnet) bereitzustellen, wobei die Veränderung der Kapazität für die Veränderung in der Umgebung des Sensorelements spezifisch sein kann. Wenigstens ein Schildelement kann wiederrum dazu dienen, eine Veränderung in einem abzuschirmenden Bereich der Umgebung vom Sensorelement abzuschirmen, sodass diese Veränderung nicht signifikant zur Veränderung der Kapazität führt.

Darüber hinaus kann es vorgesehen sein, dass für die Ansteuerung des Sensorelements ein Ansteuerungssignal genutzt wird, und für die Auswertung des Sensorelements ein Sensorsignal genutzt wird. Dabei kann das Sensorsignal vom Ansteuerungssignal abhängig sein. Auch kann eine Ladungsübertragung beim Sensorelement vom Ansteuerungssignal abhängig sein, da z. B. eine elektrische Spannung am Sensorelement dem Ansteuerungssignal folgt (bzw. der elektrischen Spannung des Ansteuerungssignals entspricht).

Es kann vorgesehen sein, dass das Sensorsignal und/oder die Ladungsübertragungen beim Sensorelement im Wesentlichen

- dieselbe Frequenz (Arbeitsfrequenz) aufweist, wie das Ansteuerungssignal, und/oder
- dieselbe Signalform aufweist, wie das Ansteuerungssignal, vorzugsweise Sinusform und/oder eine periodische oszillierende Form, und/oder
- eine Frequenz in einem Arbeitsfrequenzbereich aufweist, wobei auch die Frequenz (Arbeitsfrequenz) des Ansteuerungssignals in diesem Arbeitsfrequenzbereich liegt,
- phasengleich bzw. polaritätsgleich ausgeführt ist,
- einen gleichen Gleichspannungs- und/oder Gleichstromoffset (bzw. DC Offset) aufweist,
- ein reduziertes Frequenzspektrum aufweist, welches durch eine Filteranordnung und/oder eine Auswertefilteranordnung angepasst ist.

Ferner ist es denkbar, dass das Sensorsignal zumindest nach (oder durch) eine Filterung einer Auswertefilteranordnung als Wechselstrom (oder Wechselspannung) vorliegt. Eine Filterung kann durch die Auswertefilteranordnung auch als Bandpassfilterung ausgeführt sein. Dagegen kann eine Filterung des Ansteuerungssignals insbesondere durch die Filteranordnung als Tiefpassfilterung ausgeführt sein, um einen Gleichspannungsanteil beim Ansteuerungssignal beizubehalten.

Ferner kann es möglich sein, dass die Auswertefilteranordnung dazu ausgeführt ist, alternativ oder zusätzlich zur Bandpassfilterung eine Transkonduktanzwandlung des Sensorsignals durchzuführen. Unter einer Transkonduktanzwandlung wird dabei im Rahmen der Erfindung insbesondere verstanden, dass eine elektrische Spannung in einen dazu proportionalen und vorzugsweise gleichen elektrischen Strom umgewandelt wird. Funktional kann dies der Funktion eines Transkonduktanzverstärkers entsprechen, ggf. mit einem Verstärkungsfaktor (Proportionalitätsfaktor) von maximal 1. Jedoch kann im Gegensatz zum Transkonduktanzverstärker die Auswertefilteranordnung keinen Operationsverstärker aufweisen, sondern die Transkonduktanzwandlung mittels des komplexen Widerstands und insbesondere durch die Verschaltung in Serie mit dem virtuellen Nullpunkt erzielen.

Die Frequenz des Sensorsignals (als periodisches Signal) kann dabei abhängig sein von einer Arbeitsfrequenz, d. h. insbesondere der Frequenz des Ansteuerungssignals am Ausgang einer Filteranordnung der Kontrollanordnung. Es kann vorteilhafterweise für die gesamte erfindungsgemäße Anordnung eine einzige Arbeitsfrequenz sowohl für die Ansteuerung als auch für die Auswertung, insbesondere kapazitive Sensorauswertung, des Sensorelements genutzt werden, um die Ansteuerung und Auswertung des Sensorelements mit einem vorgegebenen Arbeitsfrequenzbereich durchzuführen. Hierzu wird insbesondere eine Filterung bei der elektrischen Ansteuerung (durch die Filteranordnung) und bei der Auswertung (durch eine Auswertefilteranordnung) genutzt, wobei die Filterung an die Arbeitsfrequenz angepasst ist (z. B. einen Tief- und/oder Bandpass zum Durchlassen des Arbeitsfrequenzbereiches ausbildet). Dies ermöglicht eine optimale Auswertung hinsichtlich EMV (Elektromagnetische Verträglichkeit) Bedingungen (bei Emissionen) und störenden Einwirkungen (bei Immissionen). Auch kann durch die Erzeugung des Ansteuerungssignals und/oder die Anpassung der Signalform und/oder Frequenz des Ansteuerungssignals eine Emission des Sensorelements und eine Störanfälligkeit für Immissionen sehr genau eingestellt werden. Um jedoch diese eingestellten Eigenschaften auch bei der Sensorauswertung nutzen zu können, kann das Sensorsignal ebenfalls entsprechend dem Ansteuerungssignal angepasst sein. Das Sensorsignal kann hierzu spezifisch sein für die Ladungsübertragungen und weist dennoch die eingestellten Eigenschaften auf. Hierzu wird z. B. eine (die) Sensorkontrollanordnung genutzt, welche das Ansteuerungssignal in Abhängigkeit von den Ladungsübertragungen (und damit der Sensorkapazität des Sensorelements) verstärkt als das Sensorsignal ausgibt. Dies ist z. B. durch den Einsatz eines Operationsverstärkers bei der Sensorkontrollanordnung möglich, welcher eine Gegenkopplung mittels eines Kondensators aufweist.

Bevorzugt kann die Speicheranordnung als ein elektronischer Integrator ausgeführt sein, insbesondere um empfangene Ladungen zu akkumulieren. Bevorzugt können mehrere Ladungsübertragungen nach mehreren Auf- und Entladungen des Sensorelements genutzt werden, um die Speicheranordnung aufzuladen.

Optional ist es denkbar, dass die Kontrollvorrichtung mindestens eine der nachfolgenden Komponenten aufweist:

-   eine Referenzeinheit, welche mit der Speicheranordnung verschaltet ist, zur Erzeugung eines Referenzsignals, insbesondere einer Referenzspannung,
-   eine Vergleichseinheit zum Vergleich eines Auswertesignals, insbesondere einer elektrischen Auswertespannung, mit einem Referenzsignal, insbesondere der Referenzspannung, wobei vorzugsweise das Auswertesignal und/oder das Referenzsignal für den jeweils nach der Ladungsübertragung vorliegenden Ladezustand, insbesondere für eine elektrische Spannung, der Speicheranordnung spezifisch sind/ist,
-   eine Initiierungseinheit, welche mit der Speicheranordnung verschaltet ist, zur Erzeugung eines Auswertesignals, insbesondere einer elektrischen Auswertespannung, vorzugsweise in Folge eines Lade- und/oder Entladevorgangs der Speicheranordnung, sodass sich das Auswertesignal, insbesondere die elektrische Auswertespannung, zeitlich während des Vergleichens verändert,
    wobei bevorzugt die Zählereinheit eine Zeitdauer in Abhängigkeit von dem Vergleich ermittelt,
-   eine Verarbeitungsvorrichtung zum Auslesen der Zeitdauer von der Zählereinheit, um die Detektion anhand der Zeitdauer durchzuführen.

Dies hat den Vorteil, dass eine Auflösung und/oder Genauigkeit bei der Ermittlung des Parameters anhand des Ladezustands erzielt werden kann, welche gegenüber herkömmlichen Lösungen deutlich verbessert ist. Die Referenzeinheit kann dabei mit der Speicheranordnung verschaltet sein, um zur Erzeugung des Referenzsignals zunächst initial den initialen Ladezustand der Speicheranordnung zu erfassen. Hierzu kann die Referenzeinheit z. B. eine initiale Analog-Digital-Messung (Analog-Digital-Wandlung) einer Spannung an der Speicheranordnung, insbesondere über einen Speicherkondensator der Speicheranordnung, durchführen, um einen initialen Spannungswert zu messen. Die Referenzeinheit kann entsprechend einen Analog-Digital-Wandler, z. B. die Kontrollvorrichtung, aufweisen. Der initial gemessene Spannungswert kann zur Bestimmung des Referenzsignals und somit als Ausgangspunkt für die weitere Messung dienen. Diese weitere Messung (umfassend die zeitliche Auswertung) kann gegenüber der Analog-Digital-Wandlung eine höhere Auflösung bereitstellen. Die Bestimmung des Referenzsignals anhand der Analog-Digital-Wandlung und insbesondere anhand des initial gemessenen Spannungswertes erfolgt z. B. abhängig von der Messmethode des Analog-Digital-Wandlers. So kann bei der Analog-Digital-Wandlung z. B. die Messmethode der sukzessiven Approximation verwendet werden. Dies kann dazu führen, dass ein gemessener Spannungswert, sofern dieser vom tatsächlichen Spannungswert abweicht, immer kleiner ist als der tatsächliche Spannungswert der Spannung der Speicheranordnung (Fehler durch Abrunden). Daher kann der initial gemessener Spannungswert abweichen von dem tatsächlichen Spannungswert der Spannung der Speicheranordnung beim initialen Ladezustand. Um eine entsprechende Korrektur vorzunehmen, kann daher die zeitliche Auswertung genutzt werden. Um die zeitliche Auswertung zu verkürzen, kann das Referenzsignal so festgelegt werden, dass dieses für einen Referenzwert spezifisch ist, welcher (insbesondere um einen Schwellenwertabstand) geringer ist als der initial gemessene Spannungswert. Diese Festlegung erfolgt vorteilhafterweise in Abhängigkeit von der (bekannten) Auflösung des Analog-Digital-Wandlers anhand des vorgegebenen Schwellenwertabstands zum gemessenen Wert. Anschließend kann die Vergleichseinheit zum Vergleich des Auswertesignals mit dem Referenzsignal genutzt werden. Das Auswertesignal kann dabei z. B. der Spannung über den Speicherkondensator der Speicheranordnung entsprechen, oder davon abhängig sein, und somit auch zur Ermittlung eines Spannungswertes dieser Spannung dienen. Die Initiierungseinheit kann dabei ggf. bei der Speicheranordnung einen Lade- und/oder Entladevorgang initiieren, sodass sich der Ladezustand ausgehend von dem initialen Ladezustand und entsprechend auch die Spannung der Speicheranordnung zeitlich (in für den initialen Ladezustand charakteristischer Weise) verändert. Hierdurch kann das Auswertesignal während des Vergleichs erzeugt werden (in Folge des Lade- und/oder Entladevorgangs, sodass sich das Auswertesignal zeitlich während des Lade- und/oder Entladevorgangs und während des Vergleichs verändert). Entsprechend sind das Auswertesignal und das Referenzsignal für den jeweils nach der Ladungsübertragung vorliegenden (initialen) Ladezustand der Speicheranordnung spezifisch, und ermöglichen somit die Erfassung des (initialen) Ladezustands. Der Unterschied ist insbesondere, dass das Referenzsignal nur auf einer Erfassung des initialen Ladezustands der Speicheranordnung zu einem (einzigen) initialen Zeitpunkt basiert, und dagegen das Auswertesignal auf einer zeitlichen Veränderung des Ladezustands ausgehend vom initialen Ladezustand basiert. Diese zeitliche Veränderung, insbesondere die Auf- oder Entladung und/oder die Zeitdauer bis zum Erreichen des Referenzwertes, ist dabei für den initialen Ladezustand spezifisch, denn es unterscheiden sich die Lade- und Entladekurven des Speicherkondensators und/oder Zeitdauern für unterschiedliche initiale Ladezustände. Damit ist auch die durch die Zählereinheit ermittelte Zeitdauer in Abhängigkeit von dem Vergleich (z. B. bis zum Erreichen des Referenzwertes durch den Spannungswert des Auswertesignals, bzw. bis zu einer Übereinstimmung des Referenz- mit dem Auswertesignal) für den initialen Ladezustand (und somit für den Parameter) spezifisch, sodass anhand dieser Zeitdauer durch die Verarbeitungsvorrichtung die Detektion durchgeführt werden kann. Insbesondere kann dabei die Zeitdauer dazu dienen, und ggf. proportional sein zu, einer Differenz des initial gemessenen Spannungswertes zu dem tatsächlichen Spannungswert. Eine Korrektur kann entsprechend beispielhaft durch die zeitliche Auswertung dadurch erfolgen, dass die mittels der Zeitdauer ermittelte Differenz auf den gemessenen Spannungswert aufaddiert wird.

Gemäß einer vorteilhaften Weiterbildung der Erfindung kann vorgesehen sein, dass die Zählereinheit zur Erfassung einer vom Ladezustand der Speicheranordnung abhängigen Zeitdauer ausgeführt ist, insbesondere einer Entladezeitdauer oder Aufladezeitdauer eines Speicherkondensators der Speicheranordnung, um hierdurch den Ladezustand der Speicheranordnung zeitlich auszuwerten, wobei insbesondere die erfasste Zeitdauer mit dem Ladezustand (oder der dazu proportionalen Spannung) der Speicheranordnung und/oder mit einer Sensorkapazität des Sensorelements korreliert. Die Zeitdauer korreliert dabei insbesondere mit einem initialen Ladezustand bzw. mit einer initialen Spannung der Speicheranordnung, vorzugsweise des Speicherkondensators. Dieser initiale Ladezustand bzw. die initiale Spannung liegt initial dann vor, wenn die Auf- und/oder Entladung (z. B. durch eine Initiierungseinheit) initiiert wird. Es handelt sich dabei um den tatsächlichen Wert des Ladezustands (oder auch der dazu proportionalen Spannung der Speicheranordnung), welcher für die Ermittlung des Parameters des Sensorelements von Interesse ist.

Um die Entladezeitdauer oder Aufladezeitdauer zu verkürzen, kann es möglich sein, dass nur bis zu einem Referenzwert der Spannung der Speicheranordnung und insbesondere über dem Speicherkondensator entladen wird oder die Entladung zeitlich ausgewertet wird. Die Spannung ist dabei insbesondere proportional zum Ladezustand. Der Referenzwert kann z. B. über ein Referenzsignal bereitgestellt werden, welches durch die Referenzeinheit erzeugt wird. Der Referenzwert kann anhand eines Messwertes der Spannung der Speicheranordnung - gemessen durch die Referenzeinheit - bestimmt werden, insbesondere als ein Wert, welcher gemäß einem festen Schwellenwertabstand vom Messwert beabstandet ist. Der Messwert wird bspw. initial durch einen Analog-Digital-Wandler gemessen, wenn der Auf- und/oder Entladevorgang (z. B. durch die Initiierungseinheit) initiiert wird. Damit ist der Messwert spezifisch für die initiale Spannung, weicht jedoch gemäß der Auflösung des Analog-Digital-Wandlers davon ab. Die zeitliche Auswertung kann dabei dazu dienen, eine Differenz des tatsächlichen Wertes der Spannung zum Messwert zu ermitteln.

Der Schwellenwertabstand ist insbesondere für die Auflösung eines Analog-Digital-Wandlers (der Referenzeinheit) spezifisch, um solche Differenzen von der zeitlichen Auswertung auszuschließen, welche durch den Analog-Digital-Wandler auch durch die niedrigere Auflösung hätten erfasst werden können. So kann bspw. bei einer bekannten Auflösung eines Analog-Digital-Wandlers der Spannungswert, welcher durch den Analog-Digital-Wandler bei der Speicheranordnung gemessen wird, anhand des Schwellenwertabstands dazu genutzt werden, den Referenzwert zu bestimmen. Alternativ kann die Entladung auch vollständig bis zu einer Spannung von 0 V bei der Speicheranordnung erfolgen.

Vorzugsweise kann vorgesehen sein, dass die Zählereinheit einen, vorzugsweise elektronischen, Timer aufweist, um die zeitliche Auswertung durchzuführen. Ein solcher Timer ist vorzugsweise bereits als Funktion bei einer Kontrollvorrichtung vorgesehen, und ermöglicht somit eine kostengünstige Verbesserung der Detektion.

Von weiterem Vorteil kann sein, dass die Speicheranordnung wenigstens einen Speicherkondensator aufweist, um den Ladezustand der Speicheranordnung als einen Ladezustand des Speicherkondensators zeitlich auszuwerten, insbesondere zu ermitteln. Um den Ladezustand zu ermitteln, kann bspw. eine elektrische Spannung über den Speicherkondensator gemessen werden. Dies ermöglicht eine einfache und zuverlässige Ermittlung des Parameters anhand des Ladezustands.

Des Weiteren kann vorgesehen sein, dass die Kontrollvorrichtung eine Vergleichseinheit in Form eines elektronischen Komparators aufweist, um die Zeitdauer zu messen, bis eine Spannung eines Speicherkondensators der Speicheranordnung als Auswertespannung eine vorgegebene Spannungsschwelle als Referenzspannung erreicht, bevorzugt unter- oder überschreitet, wobei vorzugsweise die Zeitdauer von einer elektrischen Spannung des Speicherkondensators abhängig ist. In anderen Worten kann die Zeitdauer abhängig sein von der Spannung, welche bei der Initiierung einer Auf- oder Entladung des Speicherkondensators vorliegt. Die Entladung kann auch über einen Entladewiderstand erfolgen, sodass die Zeitdauer von dem Entladewiderstand abhängig sein kann. Dieser Entladewiderstand kann seriell zum Speicherkondensator geschaltet sein. Dies ermöglicht eine zuverlässige zeitliche Auswertung.

Außerdem ist es von Vorteil, wenn die Kontrollvorrichtung eine Referenzeinheit aufweist, um den Ladezustand der Speicheranordnung zur Erzeugung eines Referenzsignals, insbesondere einer Referenzspannung, insbesondere grob, zu schätzen, und/oder dass die Referenzeinheit einen Digital-Analog-Wandler aufweist, welcher insbesondere eine Auflösung im Bereich von 2 Bit bis 10 Bit, vorzugsweise 4 Bit bis 8 Bit aufweist. Unter einer Schätzung wird insbesondere eine Messung der Spannung über den Speicherkondensator bzw. der Speicheranordnung durch den Analog-Digital-Wandler und insbesondere mit niedrigerer Auflösung verstanden, wobei die niedrigere Auflösung geringer sein kann, als die Auflösung der zeitlichen Auswertung. Die grobe Schätzung hat den Vorteil, dass die Auf- oder Entladezeitdauer reduziert werden kann, da nicht vollständig Auf- oder Entladen werden muss. Dabei kann die Schätzung dadurch erfolgen, dass mit niedriger Auflösung als bei der zeitlichen Auswertung (z. B. durch den Analog-Digital-Wandler) der initiale Ladezustand der Speicheranordnung gemessen wird. Dadurch wird bekannt, in welchem Bereich sich ein genauerer Wert für den Ladezustand befinden muss. Die anschließende zeitliche Auswertung kann dann die Ermittlung dieses genaueren Wertes nur noch auf diesen Bereich beschränken.

Bspw. kann es vorgesehen sein, dass eine Referenzeinheit dazu ausgeführt ist, ein Referenzsignal, insbesondere eine Referenzspannung, an eine Verarbeitungsvorrichtung bereitzustellen. Wobei insbesondere die Verarbeitungsvorrichtung aus dem durch die Referenzeinheit bereitgestellten Referenzsignal, insbesondere der Referenzspannung, und dem durch die Zählereinheit zeitlich ausgewerteten Ladezustand der Speicheranordnung einen Messwert für den Ladezustand der Speicheranordnung und/oder den spezifischen Parameter, insbesondere die Sensorkapazität, des Sensorelements bildet. Der Messwert kann dabei der genauere Wert für den Ladezustand sein, welcher genauer ist als der Messwert des Analog-Digital-Wandlers, durch welchen das Referenzsignal erzeugt wird. Die Verarbeitungsvorrichtung ist z. B. ein Prozessor eines Mikrocontrollers und/oder der Kontrollvorrichtung. Die Verarbeitung durch die Verarbeitungsvorrichtung kann entsprechend auf digitaler Ebene erfolgen.

Ein weiterer Vorteil im Rahmen der Erfindung ist erzielbar, wenn die Kontrollvorrichtung eine Zwischenspeichervorrichtung zur Speicherung eines Ergebnisses der zeitlichen Auswertung durch die Zählereinheit und vorangegangener Auswertungen aufweist, um eine zeitliche Veränderung des Ladezustands der Speicheranordnung und/oder einer Sensorkapazität des Sensorelements für die Detektion auszuwerten. Anhand dieser zeitlichen Veränderung kann besonders zuverlässig die Detektion durchgeführt werden. Hierzu wird bspw. durch die oder wenigstens eine weitere Verarbeitungsvorrichtung ein Vergleich der aktuellen zeitlichen Auswertung mit den vorangegangenen Auswertungen durchgeführt. Die Zwischenspeichervorrichtung ist dabei bspw. als ein flüchtiger oder nicht-flüchtiger Datenspeicher ausgeführt.

Gemäß einer vorteilhaften Weiterbildung der Erfindung kann vorgesehen sein, dass das Sensorelement als eine, vorzugsweise kapazitive, Sensorelektrode ausgebildet ist, um den für die Erfassung spezifischen Parameter als eine veränderliche Sensorkapazität des Sensorelementes bereitzustellen, wobei insbesondere die Veränderung der Sensorkapazität für die Veränderung in der Umgebung des Sensorelementes spezifisch ist. Damit kann eine kapazitive Erfassung bereitgestellt werden, welche eine besonders zuverlässige Detektion von Annäherungen oder Gesten des Aktivierungsmittels ermöglicht.

Vorteilhafterweise kann bei der Erfindung vorgesehen sein, dass die Kontrollvorrichtung zur elektrischen, vorzugsweise wiederholten, Ansteuerung des Sensorelements ausgeführt ist, um das Sensorelement wiederholt aufzuladen und/oder zu entladen in Abhängigkeit von einer Sensorkapazität des Sensorelementes, wobei insbesondere die Kontrollvorrichtung dazu ausgeführt ist, zur elektrischen Ansteuerung des Sensorelements eine Erzeugung eines Ansteuerungssignals, mit einer vorzugsweise zumindest annähernden Sinusform, zu initiieren, um die Auf- und/oder Entladung zu initiieren, wobei vorzugsweise die Kontrollvorrichtung dazu ausgeführt ist, zur Detektion der Aktivierungshandlung in Abhängigkeit von der Auf- und/oder Entladung des Sensorelements und/oder der elektrischen Ansteuerung eine Ladungsübertragung an die Speicheranordnung zu initiieren, sodass die durch die Speicheranordnung gespeicherte elektrische Ladung für die Veränderung der Sensorkapazität des Sensorelementes spezifisch ist. Die Ladungsübertragung an die Speicheranordnung kann z. B. durch ein Sensorsignal initiiert werden, welche durch eine Sensorkontrollanordnung bereitgestellt wird. Das Sensorsignal kann dabei anhand von Ladungsübertragungen bereitgestellt, insbesondere erzeugt, werden, welche zur Auf- und Entladung des Sensorelements genutzt werden. Damit kann eine komfortable Möglichkeit zur Bedienung des Fahrzeuges bereitgestellt werden.

Ebenfalls Gegenstand der Erfindung ist ein System aufweisend:

- eine erfindungsgemäße Messwerterfassungsanordnung,
- eine Kontrollvorrichtung zur Ausgabe eines Aktivierungssignals im Falle der Detektion der Aktivierungshandlung,
- ein Steuergerät, welches mit der Messwerterfassungsanordnung in einer Signalverbindung steht, um bei Empfang des Aktivierungssignals eine Aktivierung einer Öffnung und/oder Entriegelung einer Klappe am Fahrzeug auszuführen.

Damit bringt das erfindungsgemäße System die gleichen Vorteile mit sich, wie sie ausführlich mit Bezug auf eine erfindungsgemäße Messwerterfassungsanordnung beschrieben worden sind.

Ebenfalls Gegenstand der Erfindung ist ein Verfahren für eine Detektion einer Aktivierungshandlung zur Aktivierung einer Öffnung und/oder Entriegelung einer Klappe am Fahrzeug, insbesondere mithilfe einer erfindungsgemäßen Messwerterfassungsanordnung.

Hierbei ist vorgesehen, dass die nachfolgenden Schritte durchgeführt werden, vorzugsweise nacheinander in der angegebenen oder in beliebiger Reihenfolge, wobei die Schritte ggf. zumindest teilweise zeitlich parallel und/oder synchronisiert und/oder wiederholt durchgeführt werden können:

a) Durchführen einer Ansteuerung wenigstens eines Sensorelements, vorzugsweise mittels eines Ansteuerungssignals zur Initiierung von Auf- und/oder Entladungen des Sensorelements,
b) Durchführen einer Ladungsübertragung an eine elektrische Speicheranordnung in Abhängigkeit von der Ansteuerung, vorzugsweise durch eine Sensorkontrollanordnung, welche zur Durchführung der Auf- und/oder Entladungen mit dem Sensorelement verschaltet ist,
c) Durchführen einer zeitlichen Auswertung eines Ladezustandes der Speicheranordnung, insbesondere durch eine Kontrollanordnung und/oder Kontrollvorrichtung, um einen spezifischen Parameter des Sensorelementes zu ermitteln, welcher für eine Veränderung, insbesondere eine Annäherung durch ein Aktivierungsmittel, in einer Umgebung des Sensorelements spezifisch ist.

Damit bringt das erfindungsgemäße Verfahren die gleichen Vorteile mit sich, wie sie ausführlich mit Bezug auf eine erfindungsgemäße Messwerterfassungsanordnung beschrieben worden sind. Zudem kann das Verfahren geeignet sein, eine erfindungsgemäße Messwerterfassungsanordnung zu betreiben.

Außerdem ist es von Vorteil, wenn bei der zeitlichen Auswertung der Ladezustand der Speicheranordnung, insbesondere nur, anhand einer Zeitmessung erfasst wird, vorzugsweise ohne die Verwendung einer Analog-Digital-Erfassung einer von dem Ladezustand der Speicheranordnung abhängigen elektrischen Spannung oder nur mit einer, bevorzugt groben, Schätzung des Ladezustandes der Speicheranordnung mithilfe einer Analog-Digital-Erfassung, um ein Referenzsignal, insbesondere eine Referenzspannung, bereitzustellen, die mit der zeitlichen Zeitmessung zu einem (Ergebnis-) Messwert für den Ladezustand der Speicheranordnung und/oder den spezifischen Parameter, insbesondere die Sensorkapazität, des Sensorelements aufkumuliert wird. Bspw. kann zur Aufkumulierung das Referenzsignal mit der Zeitmessung kombiniert werden, z. B. durch eine Kombination des Referenzsignals und eines Differenzwertes, welcher anhand der Zeitmessung ermittelt wird. Unter der Aufkumulierung wird dabei auch verstanden, dass ein für das Referenzsignal spezifisches und/oder proportionales Signal genutzt wird, wie z. B. die Messung der initialen Spannung durch den Analog-Digital-Wandler.

Es ist möglich, dass anhand der Analog-Digital-Erfassung ein Referenzwert dadurch ermittelt wird, dass der Referenzwert stets um den gleichen Schwellenwertabstand geringer ist als der durch die Referenzeinheit und/oder der durch den Analog-Digital-Wandler gemessene Wert der Spannung der Speicheranordnung initial zum Zeitpunkt der Initiierung des Auflade- und/oder Entladevorgangs. Damit kann die Zeitdauer bei der zeitlichen Auswertung ausgehend von der Initiierung der Entladung (bzw. Aufladung) bei der Speicheranordnung bis zum Erreichen des Referenzwertes spezifisch sein für eine Differenz des gemessenen Wertes der Spannung zum tatsächlichen Wert der Spannung initial zum Zeitpunkt der Initiierung des Auflade- und/oder Entladevorgangs. Der Referenzwert kann z. B. durch eine Referenzspannung bzw. als ein Referenzsignal für die Vergleichseinheit hochgenau durch die Kontrollvorrichtung bereitgestellt werden.

Bspw. kann es vorgesehen sein, dass die zeitliche Auswertung eine Auswertung einer zeitabhängigen Eigenschaft der Speicheranordnung umfasst, vorzugsweise eine Auswertung einer Auf- und/oder Entladezeit der Speicheranordnung. Hierdurch ist die Detektion besonders zuverlässig mittels einer zeitlichen Auswertung möglich. Durch die Nutzung des Referenzsignals kann ferner die Zeitdauer für die Auf- und/oder Entladezeit weiter reduziert werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:

Figur 1    eine schematische Ansicht auf einen Heckbereich eines Fahrzeuges mit einer Anordnung und einem erfindungsgemäßen System, wobei die Anordnung und das System eine erfindungsgemäße Messwerterfassungsanordnung aufweist,

Figur 2    eine schematische Seitenansicht eines Fahrzeuges mit einer Anordnung und einem erfindungsgemäßen System,

Figur 3    ein schematisches Schaltbild von Teilen einer Anordnung,

Figur 4    ein schematisches Schaltbild von Teilen einer Anordnung,

Figur 5    eine schematische Darstellung von Teilen einer Anordnung bzw. eines erfindungsgemäßen Systems,

Figur 6    eine schematische Darstellung von Teilen einer Anordnung bzw. eines erfindungsgemäßen Systems, und

Figur 7    eine schematische Darstellung zur Visualisierung eines erfindungsgemäßen Systems,

Figur 8    eine Messwerterfassungsanordnung mit weiteren Einzelheiten,

Figur 9    eine zeitliche Auswertung anhand eines beispielhaften Signalverlaufs.

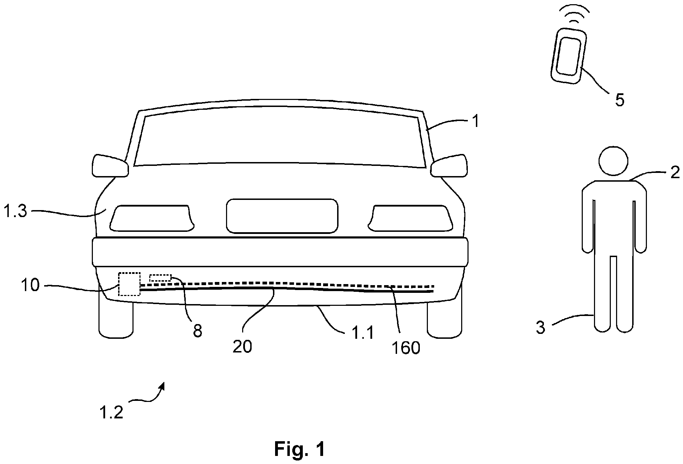

Nachfolgend wird anhand der Figuren 1 bis 7 auch eine erfindungsgemäße Anordnung 10 für ein Fahrzeug 1 beschrieben, welche eine erfindungsgemäße Messwerterfassungsanordnung 30 aufweist. Dabei kann die erfindungsgemäße Messwerterfassungsanordnung 30 auch ohne die weiteren dargestellten Teile der Anordnung 10 unter Schutz gestellt sein.

In den nachfolgenden Figuren werden für die gleichen technischen Merkmale auch von unterschiedlichen Ausführungsbeispielen die identischen Bezugszeichen verwendet.

In Figur 1 ist eine Ansicht auf einen Heckbereich 1.2 eines Fahrzeuges 1 mit einem erfindungsgemäßen System gezeigt. Eine erfindungsgemäße Anordnung 10 kann in einem Stoßfänger 1.1 des Fahrzeuges 1 integriert sein, um eine Aktivierungshandlung durch ein Aktivierungsmittel 3 (wie ein Bein 3) eines Benutzers 2 im Bereich des Stoßfängers 1.1 zu detektieren. Hierzu weist die Anordnung 10 ein Sensorelement 20 auf, welches bspw. als langgestreckte und/oder kabelförmige Elektrode 20 oder als flächige Elektrode 20 (d. h. Flachelektrode) oder als kapazitive Antenne ausgebildet sein kann. Es ist ferner möglich, dass ein Kabel, wie ein Koaxialkabel, zur Ausbildung des Sensorelements 20 genutzt wird.

Eine Detektion der Aktivierungshandlung kann dazu führen, dass eine Heckklappe 1.3 des Fahrzeuges 1 geöffnet wird. Zu diesem Zweck kann die Anordnung 10 eine Signalverbindung mit einem Steuergerät 8 des Fahrzeuges 1 aufweisen, um über die Signalverbindung ein Aktivierungssignal an das Steuergerät 8 auszugeben, welches die Öffnung der Heckklappe 1.3 initiiert. Vorausgesetzt werden kann für die Öffnung ggf. eine erfolgreiche Authentifizierung mit einem Identifikationsgeber 5. In gleicher Weise kann ggf. auch eine Klappe, insbesondere Tür 1.6, im Frontbereich 1.7 und/oder im Seitenbereich 1.4 des Fahrzeuges durch eine erfindungsgemäße Anordnung 10 aktiviert werden, wobei die Anordnung 10 dann z. B. im Türgriff 1.5 oder ebenfalls im Stoßfänger 1.1 oder an einem Seitenschweller integriert ist.

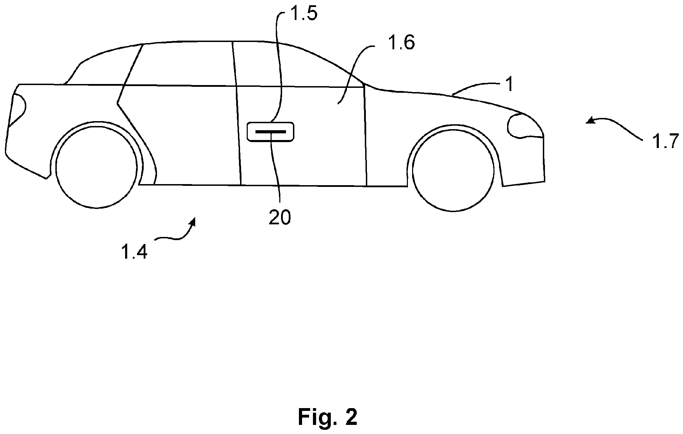

In Figur 2 ist schematisch ein Fahrzeug 1 in einer Seitenansicht gezeigt. Der Seitenbereich 1.4 und/oder der Frontbereich 1.7 des Fahrzeuges 1 kann alternativ oder zusätzlich zum Heckbereich 1.2 eine erfindungsgemäße Anordnung 10 aufweisen. Bspw. ist das Sensorelement 20 im Seitenbereich 1.4 in einen Türgriff 1.5 des Fahrzeuges integriert, um die Aktivierungshandlung im Bereich des Türgriffes 1.5 zu detektieren. So kann bspw. als eine Aktivierungshandlung eine Annäherung an das Sensorelement 20 durch die Anordnung 10 im Seitenbereich 1.4 detektiert werden. Diese Aktivierungshandlung kann ein Hineingreifen eines Aktivierungsmittels 3 (wie einer Hand) in eine Türgriffmulde des Türgriffs 1.5 umfassen. Die Anordnung des Sensorelements 20 im Frontbereich 1.7 kann wiederum im Stoßfänger 1.1 vorgesehen sein, um z. B. bei der Detektion der Aktivierungshandlung im Frontbereich 1.7 eine Frontklappe zu öffnen. Eine weitere mögliche Funktion, welche durch eine Aktivierungshandlung aktivierbar ist, kann die Öffnung von Schiebetüren 1.6 des Fahrzeuges 1 sein, z. B. durch Annäherung an einen Seitenschweller des Fahrzeuges.

Grundsätzlich kann die Aktivierungshandlung eine Annäherung an das Sensorelement 20 oder auch eine Geste oder dergleichen umfassen. Insbesondere zur Detektion von Gesten kann neben einem einzigen Sensorelement 20 noch wenigstens ein weiteres Sensorelement 20' vorgesehen sein, und benachbart zum Sensorelement 20 angeordnet sein. Dies ermöglicht es, eine Bewegung des Aktivierungsmittels durch die unterschiedliche Erfassung der Sensorelemente 20, 20' zu erkennen. Ebenfalls kann benachbart zum Sensorelement 20 und/oder weiteren Sensorelement 20' ein Schildelement 160 zur Abschirmung angeordnet sein. In Figur 1 ist beispielhaft diese Anordnung im Stoßfänger 1.1 gezeigt.

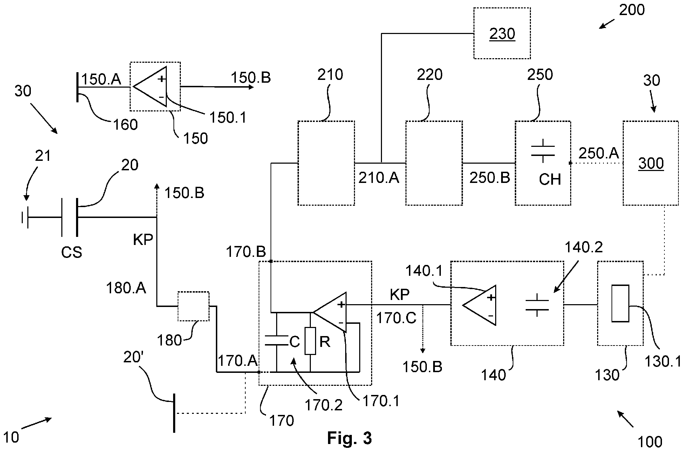

In Figur 3 ist eine erfindungsgemäße Anordnung 10 für ein Fahrzeug 1 gezeigt, welche zur Detektion einer Aktivierungshandlung für die Aktivierung einer Funktion am Fahrzeug 1, insbesondere wie gemäß Figur 1 und 2 beschrieben zur Detektion der Aktivierungshandlung in einem Front-, Seiten- und/oder Heckbereich 1.7, 1.4, 1.2 des Fahrzeuges 1 für die Aktivierung einer Öffnung und/oder Entriegelung einer Klappe 1.3, 1.6, insbesondere Tür 1.6, am Fahrzeug 1, dient.

Die erfindungsgemäße Anordnung 10 kann wenigstens ein Sensorelement 20 zur Erfassung einer Veränderung in einer Umgebung des Sensorelements 20 aufweisen. Diese Veränderung ist bspw. durch die Aktivierungshandlung bedingt, bspw. eine Annäherung durch ein Aktivierungsmittel 3. Das Sensorelement 20 kann dabei als ein elektrischer Leiter, wie eine elektrisch leitfähige Fläche (insbesondere bei einer Montage der Anordnung 10 im Türgriff 1.5) oder eine langgestreckte ggf. flächige Elektrode (insbesondere bei einer Montage im Stoßfänger 1.1) ausgebildet sein.

Die Sensitivität des Sensorelements 20 für Veränderungen in der Umgebung und damit für die Aktivierungshandlung kann bspw. wie folgt vereinfacht erklärt werden. Gegenüber der Umgebung und/oder einem Massepotential 21 kann das Sensorelement 20 eine Kapazität (im Folgenden auch als Sensorkapazität CS bezeichnet) ausbilden. Durch die Erzeugung eines elektrischen Potentials (mittels einer nachfolgend beschriebenen elektrischen Ansteuerung) an dem Sensorelement 20 kann ein elektrisches Feld in der Umgebung entstehen. Die Sensorkapazität es wird durch die Veränderung in der Umgebung beeinflusst und ist somit veränderlich. In anderen Worten korreliert die Veränderung der Sensorkapazität CS mit der Veränderung in der Umgebung, d. h. dem Vorliegen einer Aktivierungshandlung. Eine Auswertung der veränderlichen Kapazität CS kann insbesondere durch eine Auswertung der im Sensorelement 20 gespeicherten Ladungsmenge erfolgen und Rückschlüsse auf die Veränderung in der Umgebung bieten, und somit zur Detektion der Aktivierungshandlung dienen. Somit ist insbesondere die Durchführung von Ladungsübertragungen von und zu dem Sensorelement 20 geeignet, anhand der Ladungsübertragungen (wie der übertragenen Ladungsmenge und/oder der dabei erfassbaren Stromstärke und/oder Spannung) ein Sensorsignal bereitzustellen, welches für die Bestimmung der veränderlichen Kapazität CS ausgewertet werden kann.

Um die elektrische Ansteuerung durchzuführen, kann eine Kontrollanordnung 100 (im Sinne einer Steuerungsanordnung 100) genutzt werden. Die Kontrollanordnung 100 kann zur elektrischen Ansteuerung des Sensorelements 20 über einen Kontrollpfad KP mit dem Sensorelement 20 elektrisch verschaltet sein, um die Erfassung bereitzustellen (d. h. zu ermöglichen). Durch die elektrische Ansteuerung kann z. B. eine (zwangsgeführte) Auf- und Entladung des Sensorelements 20 über Ladungsübertragungen initiiert werden, um anhand dieser Ansteuerung des Sensorelements 20 die kapazitive Erfassung zu erlauben. Die elektrische Verschaltung kann z. B. mittels einer elektrischen Verbindung über Leiterbahnen einer Leiterplatte realisiert werden. Die erfindungsgemäße Anordnung 10 kann zumindest teilweise an dieser Leiterplatte als elektrische Schaltung angeordnet sein. Das Sensorelement 20 und/oder das weitere Sensorelement 20' und/oder das wenigstens eine Schildelement 160 kann dabei über einen elektrischen Anschluss der Leiterplatte mit der Kontrollanordnung 100 der Anordnung 10 über Leiterbahnen elektrisch verbunden sein, oder auch selbst als Leiterbahn ausgebildet sein. Die Erfassung wird bspw. dadurch bereitgestellt, dass ein elektrisches Potential durch die Kontrollanordnung 100 am Sensorelement 20 erzeugt wird, um das Sensorelement 20 aufzuladen, und damit wie zuvor beschrieben z. B. die Auswertung der veränderlichen Kapazität CS ermöglicht. Es kann sich dabei auch um ein wechselndes Potential handeln, sodass eine elektrische Spannung am Sensorelement 20 z. B. als periodische und/oder sinusförmige Spannung erzeugt wird. Zur Auswertung des Sensorelements 20 ist eine Auswerteanordnung 200 vorgesehen, welche eine wiederholte Ermittlung wenigstens eines für die Erfassung spezifischen Parameters des Sensorelements 20 durchführt, um die Detektion der Aktivierungshandlung durchzuführen. Im konkret beschriebenen Beispiel wird die veränderliche Kapazität CS als dieser Parameter angesehen.

Darüber hinaus ist es möglich, dass wenigstens ein Schildelement 160 vorgesehen ist, welches zur Abschirmung des Sensorelements 20 benachbart (und damit im Wirkbereich) zum Sensorelement 20 angeordnet ist. Um eine Abschirmung durch das Schildelement 160 zu ermöglichen, ist eine Schildkontrollanordnung 150 mit einem Anschluss 150.A für das Schildelement 160 vorgesehen. Die Schildkontrollanordnung 150 kann über einen Schildkontrolleingang 150.B zur Bereitstellung der (zuvor beschriebenen) elektrischen Ansteuerung der Kontrollanordnung 100 für das Schildelement 160 elektrisch mit dem Kontrollpfad KP und somit auch mit dem Schildelement 160 verbunden sein. In anderen Worten kann die Schildkontrollanordnung 150 die gleiche elektrische Ansteuerung für das Schildelement 160 bereitstellen, welche auch für das Sensorelement 20 genutzt wird. Hierzu folgt eine elektrische Ausgangsspannung an dem Ausgang 150.A der Schildkontrollanordnung 150, welcher elektrisch mit dem Schildelement 160 verbunden ist, einer Eingangsspannung an dem Eingang 150.B der Schildkontrollanordnung 150, welcher wiederrum elektrisch mit dem Kontrollpfad KP verbunden und damit auch mit dem Sensorelement 20 verschaltet ist. Für das Sensorelement 20 und für das Schildelement 160 kann auf diese Weise ein gleiches Ansteuerungssignal genutzt werden, um durch das Ansteuerungssignal das Potential am Sensorelement 20 und am Schildelement 160 in gleicher Weise einzustellen.

Zur Verbindung der Schildkontrollanordnung 150 mit dem Kontrollpfad KP kann ein Verbindungspunkt am Kontrollpfad KP genutzt werden. Hierzu kommen verschiedene Positionen am Kontrollpfad KP in Frage, z. B. unmittelbar am Strompfad zum Sensorelement 20 oder zwischen einer Filteranordnung 140 und einer Sensorkontrollanordnung 170. In Figur 3 sind beispielhaft und nicht abschließend mit gestrichelter Linie zwei mögliche Verbindungspunkte des Schildkontrolleingangs 150.B mit der Schildkontrollanordnung 150 gezeigt. Bei Verwendung des Verbindungspunkts am Anschluss 170.C der Sensorkontrollanordnung 170 kann zur Einstellung des Potentials am Schildelement 160 das Ansteuerungssignal genutzt werden, welches durch die Filteranordnung 140 ausgegeben wird. Bei der Verwendung des Verbindungspunkts unmittelbar am Strompfad zum Sensorelement 20 wird zur Einstellung des Potentials am Schildelement 160 das (im Wesentlichen) gleiche Potential genutzt, welches am Sensorelement 20 anliegt.

Um die elektrische Ansteuerung besonders zuverlässig anzugleichen, und insbesondere dabei die Komponenten am Verbindungspunkt (wie das Sensorelement 20 bzw. die Kontrollanordnung 100) nicht übermäßig zu belasten, kann die Schildkontrollanordnung 150 zur elektrischen Zwangsführung des Schildelements 160 einen Operationsverstärker 150.1 aufweisen. Dieser kann genutzt werden, um den Kontrollpfad KP mit dem Schildelement 160 zu verbinden, und so die Ausgangsspannung (auch bezeichnet als Schildspannung) am Schildelement 160 gleich zur Eingangsspannung am Kontrollpfad KP zu erzeugen. Die Eingangsspannung entspricht dabei einer Ansteuerungsspannung, welche für die elektrische Spannung am Sensorelement 20 spezifisch und/oder dazu proportional ist. Bevorzugt kann die Schildkontrollanordnung 150 einen Spannungsfolger ausbilden, sodass ein elektrisches Potential an dem Schildelement 160 dem elektrischen Potential am Kontrollpfad KP und insbesondere am Sensorelement 20 folgt. Es kann entsprechend eine direkte Gegenkopplung des Operationsverstärkers 150.1 vorgesehen sein, um einen Verstärkungsfaktor von 1 zu erhalten. Der Schildkontrolleingang 150.B kann dabei (direkt) mit dem positiven (nicht invertierenden hochohmigen) Eingang des Operationsverstärkers 150.1 elektrisch verbunden sein, sodass der Eingangswiderstand des Schildkontrolleingangs 150.B sehr groß ist, um die Spannung am Schildkontrolleingangs 150.B nur gering zu belasten. Der Schildelementanschluss 150.A kann hingegen mit dem Ausgang des Operationsverstärkers 150.1 und aufgrund der Gegenkopplung ggf. auch mit dem invertierenden Eingang des Operationsverstärkers 150.1 (direkt) elektrisch verbunden sein, um einen im Vergleich zum Eingangswiderstand niederohmigen Ausgang bereitzustellen.

Ferner ist anhand Figur 3 erkennbar, dass die Kontrollanordnung 100 eine Signalgeneratoranordnung 130 aufweist, welche für die elektrische Ansteuerung des Sensorelements 20 mit dem Sensorelement 20 elektrisch verschaltet ist, um ein elektrisches Signal zur Aufladung des Sensorelements 20 wiederholt zu erzeugen. Dieses elektrische Signal, nachfolgend auch als Ansteuerungssignal bezeichnet, kann zur beschriebenen elektrischen Ansteuerung dienen, und damit für das Sensorelement 20, ggf. auch für das weitere Sensorelement 20', und insbesondere auch für das wenigstens eine Schildelement 160 zur Einstellung des elektrischen Potentials und/oder zur elektrischen Auf- und Entladung bereitgestellt werden. Diese Bereitstellung erfolgt z. B. durch die Übertragung des elektrischen Signals über zumindest einen Teil des Kontrollpfads KP an eine Sensorkontrollanordnung 170 und/oder an eine Schildkontrollanordnung 150. Die Erzeugung des Ansteuerungssignals durch die Signalgeneratoranordnung 130 bewirkt somit, dass das Ansteuerungssignal (ggf. zuvor verändert, insbesondere gefiltert) am Anschluss 170.C vorliegt. Durch die Sensorkontrollanordnung 170 und/oder Schildkontrollanordnung 150 kann wiederum anhand des Ansteuerungssignals das Sensorelement 20, das weitere Sensorelement 20' und/oder das Schildelement 160 angesteuert werden. Hierzu wird anhand des Ansteuerungssignals eine Ladungsübertragung (Auf- und/oder Entladung) bei dem Sensorelement 20 bzw. das weitere Sensorelement 20' und/oder das Schildelement 160 initiiert (und damit auch die Entstehung eines elektrischen Feldes initiiert). Die Auswertung der Menge der übertragenen Ladung kann eine Auswertung der veränderlichen Sensorkapazität CS ermöglichen. Der zeitliche Verlauf dieser Ladungsübertragung kann durch die Formung des elektrischen Signals beeinflusst werden. Hierzu weist die Signalgeneratoranordnung 130 z. B. einen Digital-Analog-Konverter 130.1 auf, welcher auch als Teil einer Kontrollvorrichtung 300 wie eines Mikrocontrollers ausgeführt sein kann. Auch kann die Signalgeneratoranordnung 130 ggf. vollständig Teil der Kontrollvorrichtung 300 sein. Auch ist es denkbar, dass die Signalgeneratoranordnung 130 nur teilweise in die Kontrollvorrichtung 300 integriert ist, und z. B. der Digital-Analog-Konverter 130.1 separat davon ausgebildet ist. Damit kann sehr zuverlässig und genau eine bestimmte Signalform des Ansteuerungssignals bestimmt werden. Diese Signalform kann durch eine anschließende Filterung ggf. weiter geformt und/oder verbessert werden, sodass das Ansteuerungssignal anschließend bspw. eine Sinusform gemäß einer Arbeitsfrequenz aufweist. Daher kann die Kontrollanordnung 100 eine Filteranordnung 140, insbesondere ein aktives Filter 140 z. B. ein Tiefpassfilter, aufweisen. Diese kann wie gezeigt der Signalgeneratoranordnung 130 nachgeschaltet sein, um das Ansteuerungssignal zur elektrischen Ansteuerung des Sensorelements 20 über den Kontrollpfad KP gefiltert an die Sensorkontrollanordnung 170 auszugeben, insbesondere durch eine Tiefpassfilterung. Auf diese Weise lässt sich das Ansteuerungssignal mit einer bestimmten Arbeitsfrequenz formen, sodass vorzugsweise eine Emission des Sensorelements 20 durch die Filteranordnung 140 angepasst ist. Damit können vorteilhafterweise EMV (Elektromagnetische Verträglichkeit) Vorgaben bei dem Betrieb der Anordnung 10 umgesetzt werden. In anderen Worten kann die Kontrollanordnung 100 eine Filteranordnung 140, insbesondere ein aktives Filter 140, aufweisen, welches die Signalgeneratoranordnung 130 mit dem Kontrollpfad KP verbindet, um ein durch die Signalgeneratoranordnung 130 erzeugtes elektrisches Signal am Kontrollpfad KP gefiltert, insbesondere tiefpassgefiltert, und/oder geformt bereitzustellen, und dadurch als ein gefiltertes elektrisches Signal, vorzugsweise Sinussignal, bereitzustellen. Die aktive Filterung wird dabei vorzugsweise durch einen Operationsverstärker 140.1 und durch Filterelemente 140.2 wie wenigstens einen Kondensator und/oder wenigstens einen Widerstand und/oder wenigstens eine Spule ermöglicht.

Das elektrische Signal (Ansteuerungssignal) am Kontrollpfad KP und insbesondere am Anschluss 170.C kann nun ggf. über weitere Komponenten wie der Sensorkontrollanordnung 170 und über ein Schaltelement 180 (ggf. über einen Anschluss 180.A) an das Sensorelement 20 ausgegeben werden. Um die hierdurch bewirkte Ladungsübertragung an das Sensorelement 20 zu unterbrechen und z. B. wenigstens ein weiteres Sensorelement 20' aufzuladen, kann das Schaltelement 180 getaktet geöffnet und anschließend wieder geschlossen werden. Die Sensorkontrollanordnung 170 kann einen Verstärker und/oder einen Spannungsfolger und/oder einen Spannungsvervielfacher aufweisen, um ein elektrisches Potential am Anschluss 170.C in gleicher Weise am Sensorelement 20 zu erzeugen, bevorzugt sodass das elektrische Potential am Sensorelement 20 dem elektrischen Potential am Anschluss 170.C folgt. Hierzu weist die Sensorkontrollanordnung 170 z. B. einen Operationsverstärker 170.1 und/oder wenigstens ein Filterelement 170.2, wie einen Kondensator 170.2, auf. Ein weiteres Schaltelement 180 kann z. B. im Pfad zwischen dem Anschluss 170.A und dem weiteren Sensorelement 20' integriert sein, und z. B. im Wechsel mit dem Schaltelement 180 geschaltet werden.

Die Sensorkontrollanordnung 170 kann den Operationsverstärker 170.1 als ein Übertragungselement 170.1 aufweisen, welches mit der Signalgeneratoranordnung 130 elektrisch verschaltet ist, um anhand des Ansteuerungssignals (am Anschluss 170.C) wiederholte Ladungsübertragungen bei dem Sensorelement 20 zu initiieren. Dies ermöglicht eine zumindest teilweise Auf- und wieder Entladung des Sensorelements 20, und damit eine Auswertung der im Sensorelement 20 gespeicherten Ladung. Hierzu kann bspw. eine Menge (Anzahl) der übertragenen Ladungen und/oder eine Stromstärke bei den Ladungsübertragungen ausgewertet werden.

Die Ladungsmenge und/oder Stromstärke ist dann spezifisch für Sensorkapazität es, insbesondere für die Veränderung der Sensorkapazität CS. Für diese Auswertung des Sensorelements 20 kann die Sensorkontrollanordnung 170 ferner das wenigstens eine Filterelement 170.2 als ein Verstärkungsmittel 170.2 aufweisen, welches mit der Auswerteanordnung 200 (und auch mit dem Sensorelement 20) elektrisch verschaltet ist, und so anhand der Ladungsübertragungen das Sensorsignal bereitstellt. Das Sensorsignal ist spezifisch für die (z. B. proportional zur) Sensorkapazität CS. Konkret ist das Sensorsignal z. B. spezifisch für die Stromstärke des elektrischen Stroms und/oder einer Spannung, welche(r) am Anschluss 170.A vorliegt, und damit spezifisch für die Ladungsübertragungen bzw. die Sensorkapazität CS.

Um anhand des Sensorsignals Rückschlüsse auf die Sensorkapazität CS zu ermöglichen, kann das Verstärkungsmittel 170.2, wie in Figur 3 dargestellt ist, mit dem Sensorelement 20 elektrisch verschaltet sein, um Ladungsübertragungen (also einen elektrischen Stromfluss) zwischen dem Sensorelement 20 und dem Verstärkungsmittel 170.2 bereitzustellen. Ferner kann das Verstärkungsmittel 170.2 einen Ausgang des Übertragungselements 170.1 mit einem (insbesondere invertierenden) ersten Eingang des Übertragungselements 170.1 elektrisch verbinden, sodass das Verstärkungsmittel 170.2 eine Gegenkopplung für das Übertragungselement 170.1 ausbildet. Die Gegenkopplung ermöglicht es, dass die Ladungsübertragungen durch das Ansteuerungssignal gesteuert werden, wenn das Ansteuerungssignal am anderen (insbesondere nicht invertierenden) zweiten Eingang des Übertragungselements 170.1 anliegt. Wenn der erste Eingang direkt mit dem Anschluss 170.A elektrisch verbunden ist, wie es auch in Figur 3 gezeigt ist, wird auf diese Weise durch die Sensorkontrollanordnung 170 ein Spannungsfolger für das Sensorelement 20 bereitgestellt, sodass die Spannung am (insbesondere niederohmigen) Anschluss 170.A dem Ansteuerungssignal am (insbesondere hochohmigen) Anschluss 170.C folgt. Dies entspricht der Steuerung der Ladungsübertragungen am Anschluss 170.A durch das Ansteuerungssignal, und damit einer (insbesondere niederohmigen) Sensorspeisung. Das Sensorsignal kann hingegen mittels der Anordnung (Verstärkeranordnung) aus dem Übertragungselement 170.1 und dem Verstärkungsmittel 170.2 bereitgestellt werden, bei welcher es sich um einen elektronischen Verstärker handeln kann.

Vorzugsweise ist das Übertragungselement 170.1 als Operationsverstärker 170.1 ausgebildet. Das Verstärkungsmittel 170.2 weist hingegen wenigstens ein oder zwei Filterelement(e) 170.2 auf, bei welchen jedoch ein Kondensator C (z. B. gegenüber einem Widerstand R) dominieren kann. Damit kann die Konfiguration der Anordnung aus dem Übertragungselement 170.1 und dem Verstärkungsmittel 170.2 auch als eine Integrier-Schaltung angesehen werden. Der Kondensator C ermöglicht es, durch diese Anordnung einen elektronischen Verstärker bereitzustellen, bei welchem anhand der Ladungsübertragungen das Sensorsignal in der Form einer zur Sensorkapazität CS proportionalen elektrischen Spannung erzeugt wird. In anderen Worten weist die Sensorkontrollanordnung 170 die Anordnung aus dem Übertragungselement 170.1 und dem Verstärkungsmittel 170.2 aufweist, um das Sensorsignal mit einer Verstärkung bereitzustellen. Dies bedeutet, dass das Sensorsignal abhängig ist von, und vorzugsweise proportional ist zu, einer Spannung U1 an einem ersten Anschluss 170.A der Sensorkontrollanordnung 170 (bzw. an dem ersten Eingang des Operationsverstärkers 170.1), verstärkt durch einen Verstärkungsfaktor. Der Verstärkungsfaktor kann abhängig sein von, und vorzugsweise proportional sein zu, einem Verhältnis der Sensorkapazität CS zur Kapazität Cmess des Kondensators C. Die Spannung U1 (das Ausgangssignal) am Anschluss 170.A kann wiederrum durch die Nutzung des Spannungsfolgers bzw. einer direkten Gegenkopplung dem Ansteuerungssignal in der Form einer Spannung U0 am Anschluss 170.C im Wesentlichen entsprechen. Somit ergibt sich folgender Zusammenhang für das Sensorsignal, welches als Spannung U2 am Anschluss 170.B der Sensorkontrollanordnung 170 vorliegen kann:

$$U2 = U0 * (1 + CS/Cmess)$$

Es ist erkennbar, dass das Sensorsignal U2 in Abhängigkeit von der veränderlichen Sensorkapazität CS und der Kapazität Cmess verstärkt ist, d. h. als verstärkte Spannung U0 erzeugt wird. Folglich kann das Sensorsignal zur Ermittlung der Sensorkapazität CS dienen. Um die dargestellte Linearität zwischen dem Sensorsignal und der Sensorkapazität CS zu ermöglichen, wird der Widerstand R des Verstärkungsmittels 170.2 möglichst groß gegenüber $(1/(2*\pi*f0*CSmax))$ gewählt, wobei hier f0 die Arbeitsfrequenz, also insbesondere die (mittlere) Frequenz des Ansteuerungssignals, und CSmax der maximal vorgesehene Wert der Sensorkapazität CS ist. Dabei kann die Kapazität Cmess ggf. identisch zur maximalen Sensorkapazität gewählt werden. Die Einstellung von Cmess ermöglicht folglich auch die Einstellung eines Dynamikumfangs bei der Auswertung des Sensorelements 20. Darüber hinaus wird durch die Anordnung aus dem Übertragungselement 170.1 und dem Verstärkungsmittel 170.2 in Zusammenwirkung mit der Sensorkapazität CS ein Filterverhalten (insbesondere Bandpass-Verhalten) bereitgestellt, welches an die Arbeitsfrequenz angepasst sein kann.

Die maximale veränderliche Sensorkapazität ist bspw. die Kapazität (der Kapazitätswert), welche die Sensorkapazität CS bei der Aktivierungshandlung maximal annehmen kann.

Ebenfalls ist es denkbar, dass das Verstärkungsmittel 170.2 als wenigstens ein Filterelement 140.2 einen Kondensator C und/oder einen Widerstand R aufweist, wobei der Kondensator C (bzw. die Kapazität Cmess des Kondensators C) und/oder der Widerstand R an eine maximale veränderliche Sensorkapazität CS angepasst ist. Bevorzugt kann dabei die Kapazität Cmess des Kondensators C der maximalen veränderlichen Sensorkapazität CS entsprechen. Der Kondensator C kann zur Gegenkopplung bei dem Übertragungselement 170.1 (insbesondere Operationsverstärker 170.1) der Sensorkontrollanordnung 170 ausgebildet sein, und somit vorzugsweise einen Rückkopplungskondensator C ausbilden. Über den Kondensator C kann der Ausgang des Übertragungselements 170.1 und insbesondere der Ausgang 170.B, an welchem das Sensorsignal anliegt, auf einen Eingang des Übertragungselements 170.1 zurückgeführt werden. Zudem kann dieser Eingang mit dem Anschluss 170.A direkt verbunden sein, an welchem das Sensorelement 20 (ggf. über ein Schaltelement 180) angeschlossen ist, und somit das Ausgangssignal bzw. eine elektrische Spannung des Sensorelements 20 anliegt. Auf diese Weise kann das Ausgangssignal über eine direkte Gegenkopplung entsprechend dem Ansteuerungssignal erzeugt werden (diesem folgen). Zudem kann auf diese Weise das Ansteuerungssignal bzw. das Ausgangssignal abhängig von den (durch das Ausgangssignal initiierten) Ladungsübertragungen am Sensorelement 20 verstärkt (mit einem von der Sensorkapazität abhängigen Verstärkungsfaktor) werden, und sodann als das Sensorsignal verstärkt am Anschluss 170.B ausgegeben werden.

Für die Auswertung des für die Erfassung spezifischen Parameters und insbesondere der veränderlichen Sensorkapazität CS ist entsprechend den obigen Ausführungen die Ladungsübertragung vom Sensorelement 20 (bzw. des weiteren Sensorelements 20') an die Sensorkontrollanordnung 170 vorgesehen, um diese Ladungsübertragung anhand des Sensorsignals durch eine Auswerteanordnung 200 auszuwerten. Dabei wird zur wiederholten Ermittlung wiederholt eine Ladungsübertragung vom Sensorelement 20 an die Sensorkontrollanordnung 170 durchgeführt, um abhängig von der Menge der dabei übertragenen Ladung eine Speicheranordnung 250, vorzugsweise einen Integrator 250, der Auswerteanordnung 200 aufzuladen. In anderen Worten wird abhängig von, und vorzugsweise proportional zu, dem Sensorsignal die Speicheranordnung 250 aufgeladen. Auf diese Weise kann die durch die Speicheranordnung 250 gespeicherte elektrische Ladung für die Veränderung der Kapazität CS spezifisch sein. Hierzu kann die Speicheranordnung 250 z. B. mittels eines Speicherkondensators eine Speicherkapazität CL bereitstellen.

Die Kontrollvorrichtung 300 kann über einen Anschluss 250.A mit der Speicheranordnung 250 der Auswerteanordnung 200 verschaltet sein, um die durch die Speicheranordnung 250 gespeicherte elektrische Ladung zur Ermittlung des für die Erfassung spezifischen Parameters auszuwerten. Es wird somit hierbei ein Auswertesignal erfasst und ausgewertet, welches spezifisch ist für den Parameter und/oder die gespeicherte elektrische Ladung. Das Auswertesignal kann z. B. eine Spannung über einen Kondensator der Speicheranordnung 250 sein.

Ebenfalls ist in Figur 3 erkennbar, dass die Schildkontrollanordnung 150 und die Sensorkontrollanordnung 170 mit der gleichen Signalgeneratoranordnung 130 und gleichen Filteranordnung 140 über den Kontrollpfad KP elektrisch verschaltet sind. Hierdurch wird ein durch die Signalgeneratoranordnung 130 erzeugtes und/oder durch die Filteranordnung 140 gefiltertes elektrisches Signal (das Ansteuerungssignal) am Kontrollpfad KP sowohl zur Ansteuerung des Sensorelements 20 als auch des Schildelements 160 genutzt, vorzugsweise mit einer im Wesentlichen identischen Signalform des Signals, bevorzugt einer zumindest annähernden Sinusform, sodass eine elektrische Potentialdifferenz zwischen dem Sensorelement 20 und dem Schildelement 160 im Betrieb der Anordnung 10 während der Ansteuerung und/oder Erfassung stets minimiert wird. Das Schildelement 160 kann dabei als aktives Schildelement 160 (sogenanntes "Active Shield") zur aktiven Abschirmung des Sensorelements 20 ausgeführt sein, sodass mittels der Schildkontrollanordnung 150 ein elektrisches Potential am Schildelement 160 dem elektrischen Potential an dem Sensorelement 20 aktiv nachgeführt wird. Dies ermöglicht es, eine Abschirmung des Sensorelements 20 von dem Fahrzeug 1 zu verbessern und somit eine Last zu reduzieren, die zwischen dem Sensorelement 20 und dem Fahrzeug 1 vorliegt. Diese Last führt üblicherweise zu einem relativ großen Anteil bei dem Auswertesignal, welches durch die Kontrollvorrichtung 300 ausgewertet wird. Der aufgrund der veränderbaren Sensorkapazität CS variable Anteil des Auswertesignals ist somit reduziert und daher nur erschwert auswertbar. Zur Verbesserung der Auswertung wird optional eine Kompensationsanordnung 230 eingesetzt. Diese zweigt z. B. je nach Amplitude des Auswertesignals einen Teil des elektrischen Stroms von der Speicheranordnung 250 ab. Die Nutzung eines Schildelements 160, welches zur Abschirmung das gleiche Potential aufweist wie das Sensorelement 20, kann die beschriebenen Schwierigkeiten bei der Auswertung weiter reduzieren.

Es kann wiederholt eine Aufladung und Entladung des Sensorelements 20 über den ersten Anschluss 170.A der Sensorkontrollanordnung 170 mittels der Ladungsübertragungen durchgeführt werden. Diese wiederholten Auf- und Entladungen können durch das Ansteuerungssignal (aufgrund einer sich periodisch verändernden Spannungsamplitude des Ansteuerungssignals) gesteuert werden. In Abhängigkeit von den Ladungsübertragungen kann ein elektrisches Sensorsignal über den zweiten Anschluss 170.B der Sensorkontrollanordnung 170 ausgegeben werden. Es ist möglich, dass eine elektrische Filterung des Sensorsignals durchgeführt wird. Entsprechend kann es sich um eine Filterung für den Auswertezweig bei der Übertragung des Sensorsignals an die Speicheranordnung 250 handeln, welche somit keinen Einfluss auf das elektrische Signal der elektrischen Ansteuerung (am Kontrollpfad KP) und damit auf die Aufladung des Sensorelements 20 hat. Hierzu kann eine Auswertefilteranordnung 210 genutzt werden, um eine Filterung (wie z. B. eine Bandpassfilterung) des elektrischen Sensorsignals durchzuführen. Dies ermöglicht es, dass die Auswertefilteranordnung 210 störende Immissionen aus der Umgebung des Sensorelements 20 herausfiltern kann. Damit kann die Auswertefilteranordnung 210 eine EMV-Filterung von Immissionen bereitstellen. Hierzu weist die Auswertefilteranordnung 210 z. B. einen komplexen Widerstand und zusätzlich Filterelemente auf. Es ist dabei denkbar, dass die beschriebene Form (z. B. Sinusform) des elektrischen Signals der elektrischen Ansteuerung am Kontrollpfad KP (d. h. des Ansteuerungssignals) die elektrische Spannung des Signals betrifft. Die Spannung des Sensorsignals am Anschluss 170.B kann die gleiche Form aufweisen, jedoch ggf. eine (proportional zur Sensorkapazität CS) verstärkte Amplitude. Allerdings kommt es bei der Auswertung ggf. auf die Ladungsübertragung und damit den elektrischen Strom bei der Übertragung des Sensorsignals an die Speicheranordnung 250 an. Daher kann die Auswertefilteranordnung 210 einen Transkonduktanzwandler aufweisen, um eine Transkonduktanzwandlung des Sensorsignals am Anschluss 170.B durchzuführen. Unter einer solchen Transkonduktanzwandlung wird verstanden, dass eine Spannung in einen dazu proportionalen Strom umgewandelt wird. In anderen Worten kann die Auswertefilteranordnung 210 dazu ausgebildet und/oder derart in der Auswerteanordnung 200 verschaltet sein, dass aus der Spannung des elektrischen Signals (Sensorsignals) am zweiten Anschluss 170.B mit der beschriebenen Form (z. B. Sinusform) ein elektrischer Strom mit dieser Form am Ausgang 210.A der Auswertefilteranordnung 210 gebildet wird. Der Transkonduktanzwandler ist z. B. als ein Transkonduktanzverstärker (unter Verwendung eines Operationsverstärkers) ausgebildet, stellt bevorzugt jedoch die Transkonduktanzwandlung ohne Operationsverstärker aufgrund der Verschaltung mit der Speicheranordnung 250 bereit. Dies wird z. B. durch die Schaltungskonfiguration der Auswertefilteranordnung 210 in Reihe zur Speicheranordnung 250 möglich. Ferner können die nachgeschalteten Komponenten 220, 250 niederohmig sein, und/oder die Speicheranordnung 250 z. B. am Eingang 250.B den invertierenden Eingang (-) eines Verstärkungselements, und insbesondere Operationsverstärkers aufweisen. Das Verstärkungselement der Speicheranordnung 250 kann dazu ausgeführt sein, dass bei einer auftretenden Spannung am Eingang 250.B unverzüglich Gegenmaßnahmen eingeleitet werden. Hierzu kann ein Operationsverstärker die Differenzspannung seiner Eingänge mittels einer Rückkopplung auf Null regeln. Diese Vorkehrungen und/oder die Anordnung der Auswerteanordnung 200 seriell zur Speicheranordnung 250 bewirken, dass nahezu keine Spannung am Eingang 250.B bzw. Ausgang 210.A abfällt. In anderen Worten liegt an diesem Punkt (am Eingang 250.B bzw. am Ausgang 210.A, wenn diese miteinander z. B. über einen Schalter der Gleichrichteranordnung 220 verbunden sind) nahezu ein Massepotential vor, sodass dieser Punkt als ein virtueller Nullpunkt angesehen werden kann.

Der in Figur 3 gezeigte Block 220 kann ein oder mehrere Gleichrichter betreffen, und damit eine Gleichrichteranordnung 220. Die Gleichrichteranordnung 220 kann ggf. ohne Dioden oder dergleichen auskommen, sodass im Wesentlichen kein (bzw. nahezu kein) Spannungsabfall an der Gleichrichteranordnung 220 erfolgt. Dies kann bspw. dadurch umgesetzt werden, dass die Gleichrichtung mittels wenigstens eines elektronischen Schalters durchgeführt wird, welcher getaktet geschaltet wird. Auf diese Weise kann bei der Herstellung der elektrischen Verbindung des Ausgangs 210.A mit dem Eingang 250.B durch die Gleichrichteranordnung 220 und insbesondere durch den wenigstens einen Schalter ein virtueller Nullpunkt für den Eingang 250.B bzw. Ausgang 210.A bereitgestellt werden (wenn der Schalter geschlossen wird). Wenn hingegen der wenigstens eine Schalter geöffnet wird, kann der Ausgang 210.A der Auswertefilteranordnung 210 auf ein Massepotential 21 gelegt werden. Bspw. verbindet hierzu der Schalter als Wechselschalter den Ausgang 210.A mit dem Massepotential 21. Auf diese Weise kann stets zumindest annähernd ein Massepotential am Ausgang 210.A anliegen, unabhängig von der Schalterstellung des wenigstens einen Schalters bei der Gleichrichteranordnung 220. Damit wird eine Belastung der Auswertefilteranordnung 210 deutlich verringert.

Bei der beschriebenen Gleichrichtung kann es sich um eine "kohärente" Gleichrichtung durch den wenigstens einen Gleichrichter handeln. Darunter wird verstanden, dass der wenigstens eine Gleichrichter jeweils mit einem vorgegebenen Takt das elektrische Signal (Sensorsignal) von der Auswertefilteranordnung 210 an die Speicheranordnung 250 weiterleitet, vorzugsweise (phasen-) synchronisiert mit der elektrischen Ansteuerung. Dies bewirkt, dass das Sensorsignal kohärent zum Ansteuerungssignal gleichgerichtet wird. Hierzu kann jeder der Gleichrichter wenigstens einen elektronischen Schalter aufweisen. Der Takt kann dabei jeweils derart vorgegeben sein, dass nur positive (oder alternativ negative) Halbwellen einer jeweils vorgegebenen Grundschwingung bzw. Harmonischen des elektrischen Signals (z. B. mit der ersten Harmonischen als die Grundschwingung der Frequenz, welche durch die Auswertefilteranordnung 210 als Mittenfrequenz durchgelassen wird, und ggf. weiteren Harmonischen) weitergeleitet werden. Daher kann der jeweilige Takt mit der Signalgeneratoranordnung 130 synchronisiert sein, um an die Form des elektrischen Signals (Ansteuerungssignals) der elektrischen Ansteuerung angepasst zu sein. Unter Berücksichtigung der Filterung durch die Auswertefilteranordnung 210 wird bei dieser Synchronisation die Phasenverschiebung zwischen Spannung (entsprechend dem elektrischen Signal der elektrischen Ansteuerung am Kontrollpfad KP) und Strom (entsprechend dem Signal am Ausgang 210.A der Auswertefilteranordnung 210) in Betracht gezogen. Ferner kann die Gleichrichtung ggf. auch mit Dioden "inkohärent" erfolgen.

Es ist außerdem möglich, dass die Gleichrichtung in der Form einer Einweggleichrichtung erfolgt, oder dass alternativ sowohl die positive als auch die negative Halbwelle des Sensorsignals zur Ladungsübertragung an die Speicheranordnung 250 genutzt werden.

Darüber hinaus kann es vorgesehen sein, dass eine Frequenz des Sensorsignals (als periodisches Signal) abhängig ist von einer Arbeitsfrequenz, d. h. der Frequenz des Ansteuerungssignals am Anschluss 170.C (bzw. am Ausgang der Filteranordnung 140). Somit kann für die gesamte Anordnung 10 eine einzige Arbeitsfrequenz sowohl für die Ansteuerung als auch für die Auswertung des Sensorelements 20 genutzt werden, um die Ansteuerung und Auswertung des Sensorelements 20 mit einem vorgegebenen Arbeitsfrequenzbereich durchzuführen. Hierzu wird eine Filterung bei der elektrischen Ansteuerung (durch die Filteranordnung 140) und bei der Auswertung (durch die Auswertefilteranordnung 210) genutzt, wobei die Filterung an die Arbeitsfrequenz angepasst ist (z. B. einen Tief- und/oder Bandpass zum Durchlassen des Arbeitsfrequenzbereiches ausbildet). Dies ermöglicht eine optimale Auswertung hinsichtlich EMV-Bedingungen (bei Emissionen) und störenden Einwirkungen (bei Immissionen).

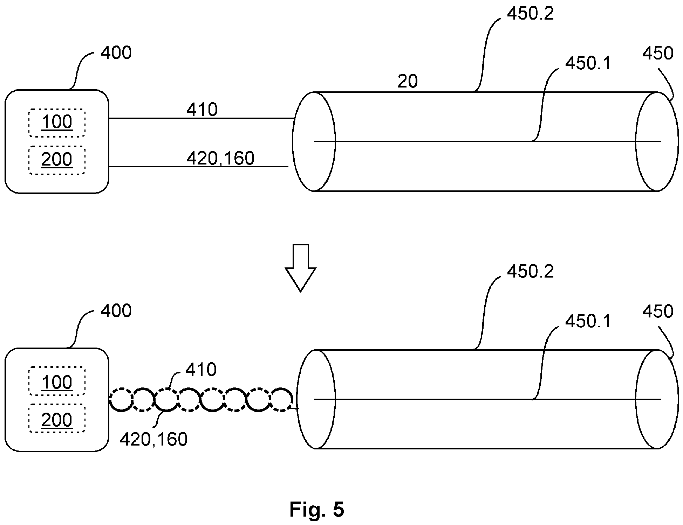

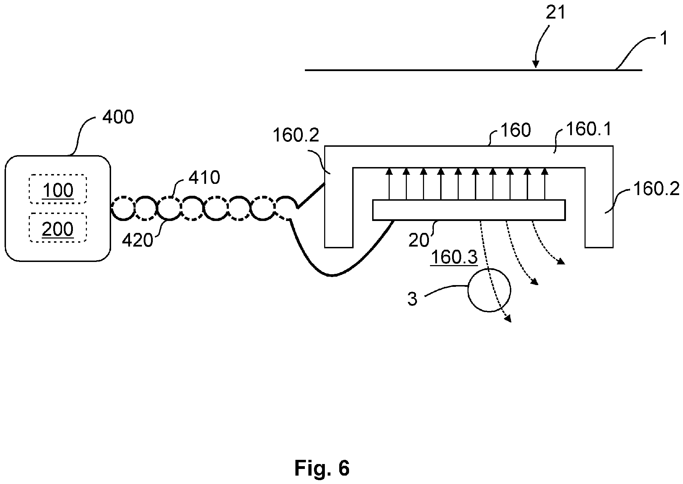

Figur 5 zeigt eine mögliche Ausgestaltung der erfindungsgemäßen Anordnung 10, wenn diese mit einem langgestreckten Sensorelement 20 genutzt wird. Eine solche Ausbildung findet bspw. Anwendung, wenn das Sensorelement 20 in einem Stoßfänger 1.1 an einer Front- oder Heckseite des Fahrzeuges 1 eingesetzt werden soll. Hierdurch ist es möglich, eine Bewegung des Aktivierungsmittels 3 unterhalb des Stoßfängers 1.1 als Aktivierungshandlung zu erfassen, wie es auch in Figur 6 verdeutlicht wird. Anders als bei einer Ausbildung des Sensorelements 20 als Leiterbahn einer Leiterplatte, wie es bei der Anordnung im Türgriff 1.5 zur Bereitstellung eines räumlich eher begrenzten Detektionsbereichs sinnvoll sein kann, wird bei einem größeren Detektionsbereich ein separates Sensorelement 20 mit der Leiterplatte verbunden. Hierzu kann z. B. ein Sensorelementanschluss 180.A der Leiterplatte genutzt werden, welcher eine elektrische Verbindung mit dem Schaltelement 180 bereitstellt. Dieses kann wiederum die elektrische Verbindung über die Sensorkontrollanordnung 170 und den Kontrollpfad KP sowie der Filteranordnung 140 zur Signalgeneratoranordnung 130 (zur Aufladung) bzw. über die Auswertefilteranordnung 210 und die Gleichrichteranordnung 220 zur Speicheranordnung 250 (zur Auswertung) bereitstellen. Die genannten Komponenten 170, 140, 130, 210, 220, 250 können ebenfalls an der Leiterplatte angeordnet sein.

Die Leiterplatte mit den Komponenten, in anderen Worten die Kontrollanordnung 100 und/oder die Auswerteanordnung 200, kann als ein gemeinsames Bauteil aufgefasst werden, welches nachfolgend als Sensorschaltanordnung 400 bezeichnet wird. Es ist optional möglich, dass diese Sensorschaltanordnung 400 als einzeln handhabbares und am Fahrzeug montierbares Teil ausgeführt ist. Die Sensorschaltanordnung 400 kann zur Montage der erfindungsgemäßen Anordnung 10 über wenigstens eine Sensorzuleitung 410 mit dem Sensorelement 20 und ggf. mit wenigstens einem weiteren Sensorelement 20' elektrisch verbunden sein. Das wenigstens eine weitere Sensorelement 20' kann dabei ggf. über wenigstens eine weitere Sensorzuleitung 410 mit der Sensorschaltanordnung 400 verbunden sein. Optional ist es zudem möglich, dass die Sensorschaltanordnung 400 über eine Schildleitung 420, insbesondere Schildzuleitung 420, mit wenigstens einem Schildelement 160 oder weiteren Schildelement elektrisch verbunden ist, oder dass die Schildleitung 420 das Schildelement 160 (d. h. ggf. auch ein weiteres Schildelement) bildet.

Als eine beispielhafte Ausgestaltung für die erfindungsgemäße Anordnung 10 ist ein Koaxialkabel 450 in Figur 5 schematisch gezeigt, deren Außenleiter 450.2 als Sensorelement 20 genutzt wird. In anderen Worten bildet der Schirm 450.2 des Koaxialkabels 450 das Sensorelement 20. Hierzu kann über den Anschluss 180.A der Sensorschaltanordnung 400 die Sensorzuleitung 410 mit dem Außenleiter 450.2 elektrisch verbunden werden. Der Anschluss 180.A überträgt dabei das elektrische Signal der elektrischen Ansteuerung, welches von der Signalgeneratoranordnung 130 und/oder der Filteranordnung 140 vorgegeben (also erzeugt und ggf. gefiltert) und ferner durch eine Sensorkontrollanordnung 170 am Anschluss 180.A ausgegeben werden kann. In gleicher Weise kann über einen Schildelementanschluss 150.A der Sensorschaltanordnung 400 eine Schildzuleitung 420 mit einem Schildelement 160 verbunden sein (siehe Figur 6) oder die mit dem Schildelementanschluss 150.A verbundene Schildleitung 420 selbst das Schildelement 160 (oder ggf. auch ein weiteres Schildelement) bilden. Insbesondere im letzteren und in Figur 5 gezeigten Fall kann es sinnvoll sein, wenn das Schildelement 160 als passives Schildelement 160 betrieben wird. Der Innenleiter 450.1 (d. h. die Seele) des Koaxialkabels 450 kann ggf. unverbunden bleiben.

Bei einem Betrieb als passives Schildelement 160 wird das Schildelement 160 im Betrieb (stets bzw. während des Auf- und/oder Entladens des Sensorelements 20) mit einem vorgegebenen konstanten elektrischen Potential über den Schildelementanschluss 150.A verbunden. Das elektrische Potential des Schildelements 160 kann dabei einem Massepotential 21 entsprechen oder ein davon abweichendes Potential sein. Im Gegensatz hierzu kann beim Betrieb als aktives Schildelement 160 das elektrische Potential des Schildelements 160 in Abhängigkeit vom elektrischen Potential des Sensorelements 20 nachgeführt und variiert werden.

Es ist über einen Pfeil in Figur 5 verdeutlicht, dass zur Montage der erfindungsgemäßen Anordnung 10 am Fahrzeug 1 eine Verdrillung der Zuleitungen 410, 420 durchgeführt werden kann. Zunächst kann dabei das Schildelement 160 in der Form einer Schildleitung 420 als langestreckte Schildelektrode 160 parallel zur Sensorzuleitung 410 verlaufen. Die Verdrillung kann z. B. durch ein Gegeneinanderverwinden und ein schraubenförmiges Umeinanderwickeln der Sensorzuleitung 410 mit der Schildleitung 420 erfolgen. Die verdrillten Zuleitungen 410, 420 sind mit einer gestrichelten und durchgehenden Linie hervorgehoben. Auf diese Weise kann die Empfindlichkeit gegenüber äußere elektromagnetische Störeinflüsse auf die Zuleitungen 410, 420 reduziert werden. Anschließend kann zur Montage die Sensorzuleitung 410 mit dem Außenleiter 450.2 elektrisch verbunden werden, sodass der Außenleiter 450.2 das Sensorelement 20 bildet. Die Schildleitung 420 sowie die Seele 450.1 des Koaxialkabels 450 bleibt ggf. unverbunden. Alternativ wird die Schildleitung 420 mit der Seele 450.1 elektrisch verbunden. Bei dieser Konfiguration ist es vorteilhaft, wenn das Schildelement 160 als passives Schildelement 160 verwendet wird.

Alternativ ist auch ein Betrieb des Schildelements 160 bzw. der Schildleitung 420 als aktives Schildelement 160 sinnvoll. Hierzu wird ggf. eine andere Verschaltung am Koaxialkabel 450 gewählt. Dabei kann die Sensorzuleitung 410 mit der Seele 450.1 (also dem Innenleiter 450.1) des Koaxialkabels 450 elektrisch verbunden werden, sodass die Seele 450.1 als Sensorzuleitung dient. Die Schildleitung 420, in diesem Fall ggf. als Schildzuleitung 420, kann mit dem Außenleiter 450.2 (d. h. mit der Abschirmung) des Koaxialkabels 450 elektrisch verbunden werden, sodass der Außenleiter 450.2 das aktive Schildelement 160 bildet. Das Koaxialkabel 450 mit der Seele 450.1 kann dabei als Zuleitung zum Sensorelement 20 dienen, welches dann allerdings separat vom Koaxialkabel 450 ausgeführt ist. Der Außenleiter 450.2 bewirkt als aktives Schildelement 160 eine verbesserte Abschirmung der Sensorzuleitung 410. Die Zuleitung 410, 420 zum Koaxialkabel 450 kann wie zuvor beschrieben verdrillt sein, oder es kann sich um parallel geführte Leitungen handeln.

Ein separates Sensorelement 20, welches z. B. über die zuvor beschriebenen verdrillten Zuleitungen 410, 420 und/oder über das Koaxialkabel 450 mit dem Außenleiter 450.2 als aktives Schildelement 160 und/oder über eine davon abweichende Variante, mit der Sensorschaltanordnung 400 verbunden ist, ist beispielhaft in Figur 6 gezeigt. Das Sensorelement 20 kann z. B. als elektrisch leitfähige Fläche (sogenannte Flachelektrode 20) und/oder als eine elektrisch leitfähige Leitung oder dergleichen ausgebildet sein. Das Sensorelement 20 ist in einer montierten Anordnung (z. B. im Heckbereich) in der Nähe zu weiteren Teilen des Fahrzeuges 1 gezeigt. Schematisch angedeutet ist dabei ein Teil des Fahrzeuges 1, welcher als Massepotential 21 angesehen werden kann. Das Fahrzeug 1 kann eine Last auf das Sensorelement 20 verursachen, welcher durch eine Abschirmung entgegengewirkt werden kann. Es wird dabei durch Pfeile das elektrische Feld verdeutlicht, welches zwischen einem Schildelement 160 und dem Sensorelement 20 auftreten kann (und durch den Betrieb des Schildelements 160 als ein aktives Schildelements 160 möglichst reduziert bzw. eliminiert werden kann), und welches zur Erfassung der Aktivierungshandlung bzw. des Aktivierungsmittels 3 dient.

Besonders vorteilhaft ist dabei die gezeigte Form des (aktiven) Schildelements 160. Die Form ist bspw. eine U-Form, wobei die beiden gegenüberstehenden Seitenteile 160.2 des Schildelements 160 einen seitlichen Bereich und ein Mittenteil 160.1 des Schildelements 160 den Mittenbereich bzw. die Fahrzeugseite abschirmt. Auf diese Weise kann der Detektionsbereich sehr genau durch den offenen Bereich 160.3 des Schildelements 160 zwischen den Seitenteilen 160.2 definiert werden. Das Schildelement 160 kann z. B. dadurch als aktives Schildelement 160 betrieben werden, dass es mit der Schild(zu)leitung 420 bzw. mit einem Außenleiter 450.2 des Koaxialkabels 450 (wenn dieses als Zuleitung verwendet wird) elektrisch verbunden wird. Das Sensorelement 20 kann ferner mit der Sensorzuleitung 410 und/oder mit der Seele 450.1 des Koaxialkabels 450 (wenn dieses als Zuleitung verwendet wird) elektrisch verbunden werden. Alternativ kann die Form auch anders als eine U-Form ausgebildet sein, insbesondere wenn das Schildelement 160 breiter ist als das Sensorelement 20.

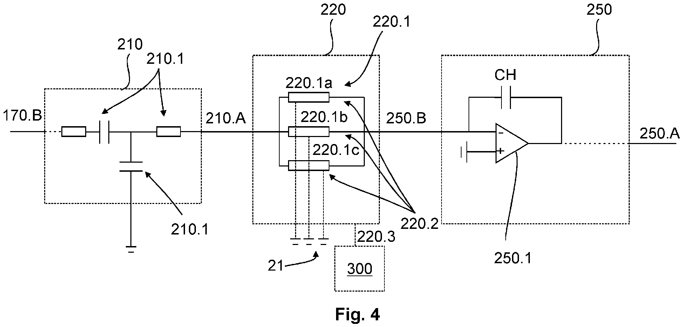

In Figur 4 ist eine Auswertefilteranordnung 210, eine Gleichrichteranordnung 220 und eine Speicheranordnung 250 mit weiteren Einzelheiten gezeigt. Die Auswertefilteranordnung 210 kann zur Filterung des Sensorsignals, welches durch die Sensorkontrollanordnung 170 bevorzugt als ein Spannungssignal bereitgestellt wird, mehrere Filterelemente 210.1 aufweisen. Diese Filterelemente können jeweils z. B. als Widerstand, Spule und/oder Kondensator ausgebildet sein, und somit als RC- und/oder als RLC- und/oder RL-Glied ausgeführt sein. Durch die Verschaltung und Auslegung der Filterelemente 210.1 kann ein Tief- und Hochpass-Verhalten der Auswertefilteranordnung 210 eingestellt werden, und damit ein Bandpass-Filter bereitgestellt werden. Dieses Bandpass-Filter ist vorteilhafterweise hinsichtlich seines Durchlassbereiches und/oder der Mittenfrequenz an eine Frequenz der elektrischen Ansteuerung, insbesondere eine Arbeitsfrequenz des Ansteuerungssignals, angepasst. Durch die serielle Verschaltung mit einem virtuellen Nullpunkt 250.B der Speicheranordnung 250 kann sodann das gefilterte Sensorsignal als ein Stromsignal an die Speicheranordnung 250 weitergeleitet werden. Dabei kann das Stromsignal eine Stromstärke aufweisen, welche hinsichtlich der Amplitude und/oder Signalform dem Spannungssignal entspricht. Auf diese Weise kann eine Ladungsübertragung an und damit Aufladung der Speicheranordnung 250 erfolgen.

Um die Ladungsübertragung nur in Richtung der Speicheranordnung 250 zu ermöglichen, kann zwischen der Auswertefilteranordnung 210 und der Speicheranordnung 250 eine Gleichrichteranordnung 220 verschaltet sein. Dabei ist es wünschenswert, dass nur bestimmte Halbwellen des Sensorsignals an die Speicheranordnung 250 weitergeleitet werden, um nur eine Aufladung der Speicheranordnung 250, jedoch keine Entladung durch das Sensorsignal zu bewirken. Die Gleichrichteranordnung 220 kann hierzu wenigstens einen steuerbaren Gleichrichter 220.1, vorzugsweise in der Form eines Synchrongleichrichters oder dergleichen, aufweisen, welcher die Gleichrichtung des Sensorsignals synchronisiert, insbesondere kohärent, d. h. insbesondere phasensynchron, zum Ansteuerungssignal durchführt. Es ist daher erforderlich, dass die Signalform des Sensorsignals (insbesondere des gefilterten Sensorsignals und damit des Stromsignals) bekannt ist. Es wird sich dabei zunutze gemacht, dass das Sensorsignal durch die Sensorkontrollanordnung 170 anhand des Ansteuerungssignals erzeugt wird, und somit der Signalform des Ansteuerungssignals entspricht (die Verstärkung gegenüber dem Ansteuerungssignal kann jedoch abhängig sein von der Sensorkapazität CS). Um die Synchronisation zu ermöglichen, kann die Gleichrichteranordnung 220, insbesondere der wenigstens eine Gleichrichter 220.1, daher durch die Kontrollvorrichtung 300 angesteuert werden. Die Kontrollvorrichtung 300 kann wiederum die Signalgeneratoranordnung 130 zur Erzeugung des Ansteuerungssignals ansteuern, sodass der Kontrollvorrichtung 300 die Signalform bekannt ist. Auf diese Weise wird die Gleichrichtung des Sensorsignals "kohärent" ermöglicht.

Ferner ist in Figur 4 zu sehen, dass die Gleichrichteranordnung 220 mehrere Gleichrichter 220.1, vorzugsweise Einweggleichrichter oder Vollweggleichrichter, aufweisen kann, welche mit der Kontrollanordnung 100 und/oder Kontrollvorrichtung 300 verschaltet sind. Beispielhaft sind ein erster Gleichrichter 220.1a, ein zweiter Gleichrichter 220.1b sowie ein dritter Gleichrichter 220.1c gezeigt. Diese dienen dazu, mit unterschiedlichen Frequenzen, insbesondere getaktet und/oder kohärent und/oder synchronisiert zum elektrischen Ansteuerungssignal, durch die Kontrollvorrichtung 300 angesteuert zu werden, derart, dass ein erster Gleichrichter 220.1a der Gleichrichter 220.1 nur eine Halbschwingung einer Grundschwingung, insbesondere ersten Harmonischen, des elektrischen Sensorsignals an die Speicheranordnung 250 weiterleitet, und der wenigstens eine weitere Gleichrichter 220.1b, 220.1c die Weiterleitung, insbesondere dieser Halbschwingung, weiterer Harmonischer des elektrischen Sensorsignals an die Speicheranordnung 250 unterdrückt. Auch kann der wenigstens eine weitere Gleichrichter 220.1b, 220.1c ggf. die Weiterleitung der anderen Halbschwingung der weiteren Harmonischen des elektrischen Sensorsignals an die Speicheranordnung 250 zulassen.

Ferner ist in Figur 4 gezeigt, dass die Gleichrichteranordnung 220 wenigstens einen elektronischen Schalter 220.2 aufweist. Insbesondere können dabei die einzelnen Gleichrichter 220.1 jeweils als ein Schalter 220.2 ausgebildet sein oder diesen aufweisen. Der wenigstens eine Schalter 220.2 (gezeigt sind in Figur 4 beispielhaft drei Schalter 220.2) kann jeweils über einen Steuerpfad 220.3 mit der Kontrollvorrichtung 300 verschaltet sein, um für bestimmte Halbschwingungen, insbesondere negative Halbschwingungen, des elektrischen Ansteuerungssignals die Speicheranordnung 250 mit der Übertragungsanordnung 170, 210 zur Übertragung des elektrischen Sensorsignals elektrisch zu verbinden. Hierzu kann jeweils ein Steuersignal des Steuerpfads 220.3 zur Umschaltung des jeweiligen Schalters 220.2 mit dem elektrischen Ansteuerungssignal synchronisiert sein. Das Steuersignal kann dabei z. B. durch die Kontrollvorrichtung 300 ausgegeben werden.

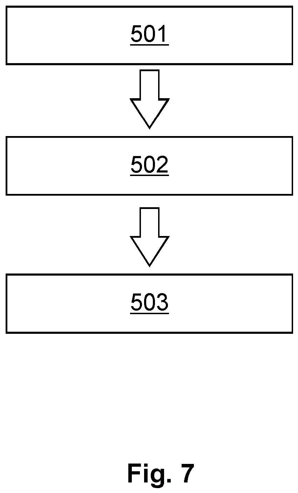

Durch Figur 7 ist ein Verfahren für das Fahrzeug 1 zur Detektion einer Aktivierungshandlung für die Aktivierung einer Funktion am Fahrzeug 1 schematisch visualisiert. Dabei erfolgt gemäß einem ersten Verfahrensschritt 501 ein Durchführen einer Ansteuerung wenigstens eines Sensorelements 20. Anschließend erfolgt gemäß einem zweiten Verfahrensschritt 502 ein Durchführen einer Ladungsübertragung an eine elektrische Speicheranordnung 250 in Abhängigkeit von der Ansteuerung. Dann erfolgt gemäß einem dritten Verfahrensschritt 503 ein Durchführen einer zeitlichen Auswertung eines Ladezustandes der Speicheranordnung 250, um einen spezifischen Parameter des Sensorelementes 20 zu ermitteln, welcher für eine Veränderung, insbesondere eine Annäherung durch ein Aktivierungsmittel 3, in einer Umgebung des Sensorelements 20 spezifisch ist.

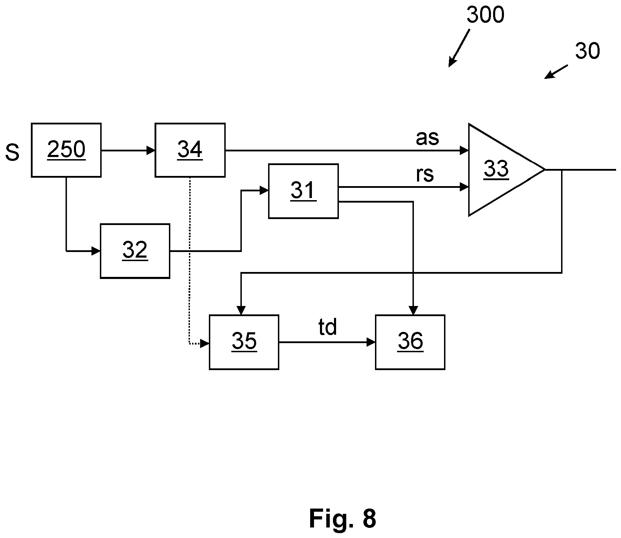

In Figur 8 ist eine erfindungsgemäße Messwerterfassungsanordnung 30 (der erfindungsgemäßen Anordnung 10) mit weiteren Einzelheiten gezeigt. Die Elemente 31 bis 36 können jeweils auch als Funktionsbauteile eines Mikrocontrollers, wie der Kontrollvorrichtung 300, ausgebildet sein. Die Messwerterfassungsanordnung 30 dient zur Anordnung an einem Fahrzeug 1 zur Detektion einer Aktivierungshandlung für eine Aktivierung, insbesondere einer Öffnung und/oder Entriegelung, einer Klappe 1.3, 1.6 am Fahrzeug 1. Es ist hierzu das wenigstens eine Sensorelement 20 zur Erfassung der Veränderung in der Umgebung des Sensorelements 20 vorgesehen und somit Teil der Messwerterfassungsanordnung 30. Ferner ist die Kontrollvorrichtung 300 zur Ermittlung des wenigstens einen für die Erfassung spezifischen Parameters des Sensorelements 20 vorgesehen, um die Detektion der Aktivierungshandlung durchzuführen. Eine elektrische Speicheranordnung 250 kann zur Ladungsübertragung mit dem wenigstens einen Sensorelement 20 verschaltet sein, wobei die Ladungsübertragung für den Parameter des Sensorelements 20 spezifisch ist. Die Kontrollvorrichtung 300 kann zudem eine Zählereinheit 35 aufweisen, welche mit der Speicheranordnung 250 verschaltet ist, um den Ladezustand der Speicheranordnung 250 zeitlich auszuwerten.

Es kann zur Verbesserung der zeitlichen Auswertung eine Referenzeinheit 31 genutzt werden, welche hierzu z. B. einen Analog-Digital-Wandler 32 aufweist oder mit einem Analog-Digital-Wandler 32 elektrisch verschaltet ist. Die Referenzeinheit 31 kann den Analog-Digital-Wandler 32 nutzen, um eine Spannung S bei der Speicheranordnung 250 zu ermitteln. Die Referenzeinheit 31 kann entsprechend mit der Speicheranordnung 250 verschaltet sein, um ein Referenzsignal rs, insbesondere die Spannung S als eine Referenzspannung, zu erzeugen. Alternativ kann das Referenzsignal rs auch stets einen festen Wert aufweisen, und somit die zeitliche Auswertung ohne die dynamische Erzeugung des Referenzsignals rs durch den Analog-Digital-Wandler 32 auskommen.

Konkret kann zur Durchführung der zeitlichen Auswertung eine Vergleichseinheit 33 einen Vergleich eines Auswertesignals as, insbesondere einer elektrischen Auswertespannung, mit dem Referenzsignal rs, insbesondere der Referenzspannung, ausführen. Hierzu ist die Vergleichseinheit 33 z. B. als ein Komparator ausgeführt, und weist daher ggf. wenigstens einen elektronischen Differenzverstärker auf. Vorzugsweise ist das Auswertesignal as und/oder das Referenzsignal rs für den jeweils nach der Ladungsübertragung vorliegenden Ladezustand, insbesondere für die elektrische Spannung S, der Speicheranordnung 250 spezifisch. Eine Initiierungseinheit 34 kann vorgesehen sein, welche mit der Speicheranordnung 250 verschaltet ist, zur Erzeugung eines Auswertesignals as, insbesondere einer elektrischen Auswertespannung, vorzugsweise in Folge eines Lade- und/oder Entladevorgangs der Speicheranordnung 250, sodass sich das Auswertesignal as, insbesondere die elektrische Auswertespannung, zeitlich während des Vergleichens verändert. Die Initiierungseinheit 34 umfasst hierzu bspw. einen elektronischen Schalter, welcher den Lade- und/oder Entladevorgang durch das Schließen eines Entlade- (bzw. Auflade-) Stromkreises initiiert. Außerdem kann die Zählereinheit 35 eine Zeitdauer td in Abhängigkeit von dem Vergleich ermitteln, und eine Verarbeitungsvorrichtung 36 ein Auslesen der Zeitdauer td von der Zählereinheit 35 durchführen, um die Detektion anhand der Zeitdauer td durchzuführen. Die Zeitdauer td wird bspw. dadurch ermittelt, dass zunächst die Initiierungseinheit 34 bei Initiierung des Lade- und/oder Entladevorgangs die Zählereinheit 35 startet, und die Vergleichseinheit 33 die Zählereinheit 35 ansteuert, und dadurch stoppt, wenn das Auswertesignal as das Referenzsignal rs unterschreitet, bzw. umgekehrt. Diese Ansteuerung der Zählereinheit 35 durch die Initiierungseinheit 34 und die Vergleichseinheit 33 ist durch Pfeile schematisch visualisiert. Die Ansteuerung durch die Vergleichseinheit 33 kann ggf. auch dadurch erfolgen, dass die Zählereinheit 35 das Ausgangssignal der Vergleichseinheit 33 auswertet.

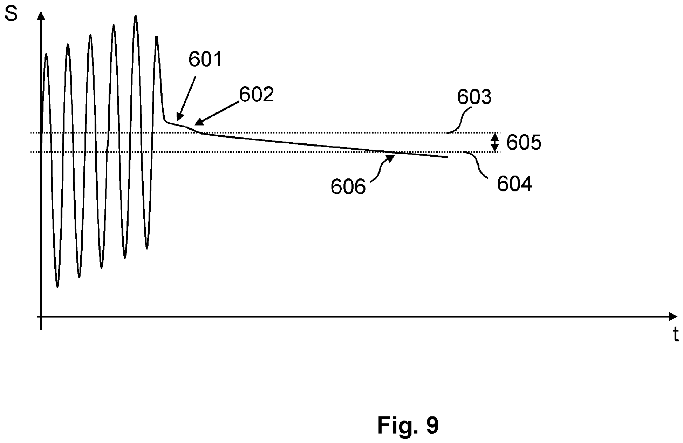

In Figur 9 ist die zeitliche Auswertung anhand eines beispielhaften Signalverlaufs der elektrischen Spannung S über den Speicherkondensator 251 der Speicheranordnung 250 über die Zeit t gezeigt. Das Auswertesignal as kann dieser Spannung entsprechen oder sich daraus ableiten. Die zeitliche Auswertung wird durchgeführt, wenn eine Aufladung der Speicheranordnung 250 anhand des Sensorsignals erfolgt ist, ggf. auch nach mehreren Auflade-Vorgängen und damit nach einer Ladungsakkumulation durch die Speicheranordnung 250. Hierzu ist die Speicheranordnung 250 z. B. als ein Integrator ausgebildet. Der Ladezustand der Speicheranordnung 250 und konkret des Speicherkondensators 251 ist dann spezifisch für den Parameter des Sensorelements 20.

Um den Ladezustand für die Ermittlung des Parameters zu erfassen, wird die zeitliche Auswertung durchgeführt.

Zunächst erfolgt zur Vorbereitung bzw. Optimierung der zeitlichen Auswertung eine AD-Wert-Erfassung 601, d. h., es wird durch den Analog-Digital-Wandler 32 ein Messwert 603 für die Spannung S erfasst, um daraus das Referenzsignal rs zu bestimmen. In anderen Worten wird der Analog-Digital-Wandler 32 durch die Referenzeinheit 31 genutzt, um den Ladezustand (anhand der Spannung S) der Speicheranordnung 250 zur Erzeugung des Referenzsignals, insbesondere der Referenzspannung, nur mit niedriger Auflösung zu messen und damit zu schätzen. Dabei kann die Referenzeinheit 31 den Digital-Analog-Wandler 32 aufweisen. Es ist anhand Figur 9 erkennbar, dass der Messwert 603 (gekennzeichnet durch eine gestrichelte Linie), welcher die Spannung S repräsentieren soll, aufgrund der niedrigen Auflösung (insbesondere Quantisierungsfehlers) des Analog-Digital-Wandlers 32 unterhalb des realen Wertes der Spannung S zum Zeitpunkt der AD-Wert-Erfassung 601 liegt (der tatsächliche Wert wird somit unterschätzt). Jedoch kann aus dem Messwert 603 der Referenzwert 604 gebildet werden, um die maximale Zeitdauer für die zeitliche Auswertung zu verkürzen. Hierzu kann ein Schwellenwertabstand 605 zwischen dem Messwert 603 und dem Referenzwert 604 genutzt werden, welcher z. B. abhängig ist von Auflösung des Analog-Digital-Wandlers 32. Bspw. wird der Schwellenwertabstand 605 so gewählt, dass davon ausgegangen werden kann, dass der Analog-Digital-Wandler 32 bei einer Spannung S (unterhalb) angrenzend zum Referenzwert 604 aufgrund der geringeren Auflösung (insbesondere in der Form eines Quantisierungsfehlers) immer einen anderen Spannungswert (oder den korrekten Spannungswert) als Messwert ermittelt, jedoch innerhalb des Schwellenwertabstandes 605 aufgrund der niedrigen Auflösung nicht. Die Bereitstellung des Referenzwertes 604 kann z. B. durch die Referenzeinheit 31 dadurch erfolgen, dass anhand des Messwertes 603 (subtrahiert mit dem Schwellenwertabstand) die Referenzeinheit 31 die Referenzspannung bzw. das Referenzsignal rs gemäß dem Referenzwert 604 (sehr genau) erzeugt.

Anschließend kann zum Zeitpunkt 602 die Messwerterfassung gemäß der zeitlichen Auswertung beginnen. Hierzu wird ein Entladevorgang initiiert (alternativ ein Ladevorgang) und ausgehend von dieser Initiierung die zeitliche Dauer td durch die Zählereinheit 35 bis zum Erreichen des Referenzwertes 604 ermittelt. Insbesondere wird der Referenzwert 604 dabei für jede zeitliche Auswertung mit demselben Schwellenwertabstand 605 zum gemessenen AD-Wert 603 (Messwert 603) festgelegt, sodass der Schwellenwertabstand 605 ggf. nur oder primär von dem verwendeten Messverfahren und/oder Analog-Digital-Wandler 32 abhängig ist. Bei Erreichen des Referenzwertes 604 (d. h. des Referenzsignals rs) durch die Spannung S (d. h. durch das Auswertesignal as) beim Entladevorgang (bzw. Ladevorgang) kann die Messwerterfassung beendet werden (Zeitpunkt 606) und die zeitliche Dauer td ausgewertet werden. Innerhalb des Schwellenwertabstands 605 erfolgt im gezeigten Beispiel ein Absinken der Spannung S, dieser Verlauf hat somit die Form einer Rampe. Die Steigung dieses Verlaufs ist bspw. -1,5 mV / µs. Aus der Zeitinformation (die zeitliche Dauer td) kann somit die Differenz des Messwertes 603 zum tatsächlichen Wert der Spannung S zum Zeitpunkt 601 ermittelt werden. Je kürzer die zeitliche Dauer td, desto näher liegt der Messwert 603 beim tatsächlichen Wert (dies ist selbstverständlich abhängig vom Messprinzip des Analog-Digital-Wandlers 32 und kann daher variieren). Um den tatsächlichen Wert zu ermitteln, kann ggf. der Spannungswert gemäß den Stufen des Analog-Digital-Wandlers 32 (gemäß dem Quantisierungsfehler) bis zum Messwert 603 zur ermittelten Differenz aufaddiert werden.

## Bezugszeichenliste

| | |
|---|---|
| 1 | Fahrzeug |
| 1.1 | Stoßfänger |
| 1.2 | Heckbereich |
| 1.3 | Heckklappe |
| 1.4 | Seitenbereich |
| 1.5 | Türgriff |
| 1.6 | Tür |
| 1.7 | Frontbereich |
| 2 | Benutzer |
| 3 | Aktivierungsmittel |
| 5 | Identifikationsgeber |
| 8 | Steuergerät |
| | |
| 10 | Anordnung |
| | |
| 20 | Sensorelement, Sensorelektrode |
| 20' | weiteres Sensorelement |
| 21 | Massepotential |
| | |
| 30 | Messwerterfassungsanordnung |
| 31 | Referenzeinheit |
| 32 | Analog-Digital-Wandler |
| 33 | Vergleichseinheit |
| 34 | Initiierungseinheit |
| 35 | Zählereinheit |
| 36 | Verarbeitungsvorrichtung |
| | |
| 100 | Kontrollanordnung |

| | |
|---|---|
| 130 | Signalgeneratoranordnung, Signalgenerator |
| 130.1 | Digital-Analog-Konverter |
| | |
| 140 | Filteranordnung, Aktives Filter, Sinusfilter |
| 140.1 | Operationsverstärker |
| 140.2 | Filterelement |
| | |
| 150 | Schildkontrollanordnung |
| 150.A | Schildelementanschluss |
| 150.1 | Operationsverstärker |
| | |
| 160 | Schildelement |
| 160.1 | Mittenteil |
| 160.2 | Seitenteil, Schenkel |
| 160.3 | Detektionsbereich, offener Bereich |
| | |
| 170 | Sensorkontrollanordnung, Spannungsfolger |
| 170.A | erster Anschluss von 170 |
| 170.B | zweiter Anschluss von 170 |
| 170.1 | Operationsverstärker |
| 170.2 | Filterelement |
| | |
| 180 | Schaltelement |
| 180.A | Ausgang von 180, Sensorelementanschluss |
| | |
| 200 | Auswerteanordnung |
| 210 | Auswertefilteranordnung |
| 210.A | erster Anschluss bzw. Ausgang von 210 |
| | |
| 220 | Gleichrichteranordnung |
| | |
| 230 | Kompensationsanordnung |
| | |
| 250 | Speicheranordnung, Integrator |
| 250.A | erster Anschluss |
| 250.B | zweiter Anschluss, Eingang |
| 251 | Speicherkondensator |
| | |
| 300 | Kontrollvorrichtung, Mikrocontroller |
| 301 | Zwischenspeichervorrichtung |
| | |
| 400 | Sensorschaltanordnung |
| | |
| 410 | Sensorzuleitung |
| | |
| 420 | Schildzuleitung |
| | |
| 450 | Koaxialkabel |
| 450.1 | Innenleiter, Seele |
| 450.2 | Außenleiter |
| | |
| 601 | AD-Wert wird erfasst |
| 602 | Messwerterfassung beginnt |
| 603 | gemessener AD-Wert |
| 604 | Referenzwert |
| 605 | Schwellenwertabstand |
| 606 | Messwerterfassung beendet, Komparator löst aus |

| | |
|---|---|
| dD | Zählerwert |
| Uref | analoges Referenzsignal |
| rs | Referenzsignal |
| t | Zeit |
| td | Zeitdauer |
| DAC | Digital-Analog-Wandler |
| CL | Speicherkapazität |
| CS | Sensorkapazität |
| D | digitales Referenzsignal |
| ADC | Analog-Digital-Wandler |
| KP | Kontrollpfad |
| S | Spannung |
| U | analoges Auswertsignal |
| as | Auswertesignal |

**Patentansprüche**

1. Messwerterfassungsanordnung (30) für ein Fahrzeug (1) zur Detektion einer Aktivierungshandlung für eine Aktivierung, insbesondere einer Öffnung und/oder Entriegelung, einer Klappe (1.3, 1.6) am Fahrzeug (1), aufweisend:

   - wenigstens ein Sensorelement (20) zur Erfassung einer Veränderung, insbesondere einer Annäherung durch ein Aktivierungsmittel (3), in einer Umgebung des Sensorelements (20),
   - eine Kontrollvorrichtung (300) zur Ermittlung wenigstens eines für die Erfassung spezifischen Parameters des Sensorelements (20), um die Detektion der Aktivierungshandlung durchzuführen,
   - eine elektrische Speicheranordnung (250), welche zur Ladungsübertragung mit dem wenigstens einen Sensorelement (20) verschaltet ist, wobei die Ladungsübertragung für den Parameter des Sensorelements (20) spezifisch ist, wobei die Kontrollvorrichtung (300) eine Zählereinheit (35) aufweist, welche mit der Speicheranordnung (250) verschaltet ist, um einen Ladezustand der Speicheranordnung (250) zeitlich auszuwerten, **dadurch gekennzeichnet dass** eine Referenzeinheit (31) dazu ausgeführt ist, ein Referenzsignal an eine Verarbeitungsvorrichtung (36) bereitzustellen, wobei die Verarbeitungsvorrichtung (36) aus dem durch die Referenzeinheit (31) bereitgestellten Referenzsignal und dem durch die Zählereinheit zeitlich ausgewerteten Ladezustand der Speicheranordnung (250) einen Messwert für den Ladezustand der Speicheranordnung (250) und/oder den spezifischen Parameter des Sensorelements (20) bildet.

2. Messwerterfassungsanordnung (30) nach Anspruch 1, **dadurch gekennzeichnet,**

**dass** die Kontrollvorrichtung (300) mindestens eine der nachfolgenden Komponenten aufweist:

- eine Referenzeinheit (31), welche mit der Speicheranordnung (250) verschaltet ist, zur Erzeugung eines Referenzsignals (rs), insbesondere einer Referenzspannung,
- eine Vergleichseinheit (33) zum Vergleich eines Auswertesignals (as), insbesondere einer elektrischen Auswertespannung, mit einem Referenzsignal (rs), insbesondere der Referenzspannung, wobei vorzugsweise das Auswertesignal (as) und/oder das Referenzsignal (rs) für den jeweils nach der Ladungsübertragung vorliegenden Ladezustand, insbesondere für eine elektrische Spannung (S), der Speicheranordnung (250) spezifisch sind/ist,
- eine Initiierungseinheit (34), welche mit der Speicheranordnung (250) verschaltet ist, zur Erzeugung eines Auswertesignals (as), insbesondere einer elektrischen Auswertespannung, vorzugsweise in Folge eines Lade- und/oder Entladevorgangs der Speicheranordnung (250), sodass sich das Auswertesignal (as), insbesondere die elektrische Auswertespannung, zeitlich während des Vergleichens verändert, wobei bevorzugt die Zählereinheit (35) eine Zeitdauer (td) in Abhängigkeit von dem Vergleich ermittelt,
- eine Verarbeitungsvorrichtung (36) zum Auslesen der Zeitdauer (td) von der Zählereinheit (35), um die Detektion anhand der Zeitdauer (td) durchzuführen.

3.   Messwerterfassungsanordnung (30) nach Anspruch 1 oder 2,
     **dadurch gekennzeichnet,**
     **dass** die Zählereinheit (35) zur Erfassung einer vom Ladezustand der Speicheranordnung (250) abhängigen Zeitdauer (td) ausgeführt ist, insbesondere einer Entladezeitdauer oder Aufladezeitdauer eines Speicherkondensators (251) der Speicheranordnung (250), um hierdurch den Ladezustand der Speicheranordnung (250) zeitlich auszuwerten, wobei insbesondere die erfasste Zeitdauer (td) mit dem Ladezustand der Speicheranordnung (250) und/oder mit einer Sensorkapazität (CS) des Sensorelements (20) korreliert.

4.   Messwerterfassungsanordnung (30) nach einem der vorhergehenden Ansprüche,
     **dadurch gekennzeichnet,**
     **dass** die Zählereinheit (35) einen, vorzugsweise elektronischen, Timer aufweist, um die zeitliche Auswertung durchzuführen.

5.   Messwerterfassungsanordnung (30) nach einem der vorhergehenden Ansprüche,

**dadurch gekennzeichnet,**
**dass** die Speicheranordnung (250) wenigstens einen Speicherkondensator (251) aufweist, um den Ladezustand der Speicheranordnung (250) als einen Ladezustand des Speicherkondensators (251) zeitlich auszuwerten, insbesondere zu ermitteln.

6.   Messwerterfassungsanordnung (30) nach einem der vorhergehenden Ansprüche,
     **dadurch gekennzeichnet,**
     **dass** die Kontrollvorrichtung (300) eine Vergleichseinheit (33) in Form eines elektronischen Komparators (33) aufweist, um die Zeitdauer (td) zu messen, bis eine Spannung eines Speicherkondensators (251) der Speicheranordnung (250) als Auswertespannung eine vorgegebene Spannungsschwelle als Referenzspannung erreicht, bevorzugt unter- oder überschreitet, wobei vorzugsweise die Zeitdauer (td) von einer elektrischen Spannung des Speicherkondensators (251) abhängig ist.

7.   Messwerterfassungsanordnung (30) nach einem der vorhergehenden Ansprüche,
     **dadurch gekennzeichnet,**

     **dass** die Kontrollvorrichtung (300) eine Referenzeinheit (31) aufweist, um den Ladezustand der Speicheranordnung (250) zur Erzeugung eines Referenzsignals, insbesondere einer Referenzspannung, insbesondere grob, zu schätzen,
     und/oder dass die Referenzeinheit (31) einen Digital-Analog-Wandler (32) aufweist, welcher insbesondere eine Auflösung im Bereich von 2 Bit bis 10 Bit, vorzugsweise 4 Bit bis 8 Bit aufweist.

8.   Messwerterfassungsanordnung (30) nach einem der vorhergehenden Ansprüche,
     **dadurch gekennzeichnet,**
     **dass** die Kontrollvorrichtung (300) eine Zwischenspeichervorrichtung (301) zur Speicherung eines Ergebnisses der zeitlichen Auswertung durch die Zählereinheit (35) und vorangegangener Auswertungen aufweist, um eine zeitliche Veränderung des Ladezustands der Speicheranordnung (250) und/oder einer Sensorkapazität (CS) des Sensorelements (20) für die Detektion auszuwerten.

9.   Messwerterfassungsanordnung (30) nach einem der vorhergehenden Ansprüche,
     **dadurch gekennzeichnet,**

     **dass** das Sensorelement (20) als eine, vorzugsweise kapazitive, Sensorelektrode (20) ausgebildet ist, um den für die Erfassung spezifischen Parameter als eine veränderliche Sensorkapazität (CS) des Sensorelementes (20) bereitzustellen,

wobei insbesondere die Veränderung der Sensorkapazität (CS) für die Veränderung in der Umgebung des Sensorelementes (20) spezifisch ist.

10. Messwerterfassungsanordnung (30) nach einem der vorhergehenden Ansprüche, **dadurch gekennzeichnet,**

dass die Kontrollvorrichtung (300) zur elektrischen, vorzugsweise wiederholten, Ansteuerung des Sensorelements (20) ausgeführt ist, um das Sensorelement (20) wiederholt aufzuladen und/oder zu entladen in Abhängigkeit von einer Sensorkapazität (CS) des Sensorelementes (20),

wobei insbesondere die Kontrollvorrichtung (300) dazu ausgeführt ist, zur elektrischen Ansteuerung des Sensorelements (20) eine Erzeugung eines Ansteuerungssignals, mit einer vorzugsweise zumindest annähernden Sinusform, zu initiieren, um die Auf- und/oder Entladung zu initiieren,

wobei vorzugsweise die Kontrollvorrichtung (300) dazu ausgeführt ist, zur Detektion der Aktivierungshandlung in Abhängigkeit von der Auf- und/oder Entladung des Sensorelements und/oder der elektrischen Ansteuerung eine Ladungsübertragung an die Speicheranordnung (250) zu initiieren, sodass die durch die Speicheranordnung (250) gespeicherte elektrische Ladung für die Veränderung der Sensorkapazität (CS) des Sensorelementes (20) spezifisch ist.

11. System aufweisend:

- eine Messwerterfassungsanordnung (30) gemäß einem der vorhergehenden Ansprüche,
- eine Kontrollvorrichtung (300) zur Ausgabe eines Aktivierungssignals im Falle der Detektion der Aktivierungshandlung,
- ein Steuergerät (8), welches mit der Messwerterfassungsanordnung (30) in einer Signalverbindung steht, um bei Empfang des Aktivierungssignals eine Aktivierung einer Öffnung und/oder Entriegelung einer Klappe (1.3, 1.6) am Fahrzeug (1) auszuführen.

12. Verfahren für eine Detektion einer Aktivierungshandlung zur Aktivierung einer Öffnung und/oder Entriegelung einer Klappe (1.3, 1.6) am Fahrzeug (1) mithilfe einer Messwerterfassungsanordnung (30) nach einem der vorhergehenden Ansprüche, wobei die nachfolgenden Schritte durchgeführt werden:

a) Durchführen einer Ansteuerung wenigstens eines Sensorelements (20),

b) Durchführen einer Ladungsübertragung an eine elektrische Speicheranordnung (250) in Abhängigkeit von der Ansteuerung,

c) Durchführen einer zeitlichen Auswertung eines Ladezustandes der Speicheranordnung (250), um einen spezifischen Parameter des Sensorelementes (20) zu ermitteln, welcher für eine Veränderung, insbesondere eine Annäherung durch ein Aktivierungsmittel (3), in einer Umgebung des Sensorelements (20) spezifisch ist.

13. Verfahren nach einem der vorhergehenden Ansprüche, **dadurch gekennzeichnet,**

dass bei der zeitlichen Auswertung der Ladezustand der Speicheranordnung (250), insbesondere nur, anhand einer Zeitmessung erfasst wird,

vorzugsweise ohne die Verwendung einer Analog-Digital-Erfassung einer von dem Ladezustand der Speicheranordnung (250) abhängigen elektrischen Spannung oder nur mit einer, bevorzugt groben, Schätzung des Ladezustandes der Speicheranordnung (250) mithilfe einer Analog-Digital-Erfassung, um ein Referenzsignal, insbesondere eine Referenzspannung, bereitzustellen, die mit dem durch die Zählereinheit zeitlich ausgewerteten Ladezustand der Speicheranordnung (250) zu einem Messwert für den Ladezustand der Speicheranordnung (250) und/oder den spezifischen Parameter, insbesondere die Sensorkapazität (CS), des Sensorelements (20) aufkummuliert wird.

14. Verfahren nach einem der vorhergehenden Ansprüche, **dadurch gekennzeichnet,** **dass** die zeitliche Auswertung eine Auswertung einer zeitabhängigen Eigenschaft der Speicheranordnung (250) umfasst, vorzugsweise eine Auswertung einer Auf- und/oder Entladezeit der Speicheranordnung (250).

## Claims

1. Measured value acquisition arrangement (30) for a vehicle (1) for detecting an activation action for an activation, in particular an opening and/or unlocking, of a flap (1.3, 1.6) on the vehicle (1):

- at least one sensor element (20) for detecting a change, in particular an approach by an activation means (3), in an environment of the sensor element (20),
- a control device (300) for determining at least one parameter of the sensor element (20) specific to the detection in order to perform the detection of the activation action,
- an electrical storage arrangement (250) which is connected to the at least one sensor element (20) for charge transfer, wherein the charge transfer is specific to the parameter of the sensor element (20),
the control device (300) having a counter unit (35) which is connected to the storage arrangement (250) in order to evaluate a charge state of the storage arrangement (250) over time, **characterized in that**
a reference unit (31) is designed to provide a reference signal to a processing device (36), wherein the processing device (36) forms a measured value for the charge state of the storage arrangement (250) and/or the specific parameter of the sensor element (20) from the reference signal provided by the reference unit (31) and the charge state of the storage arrangement (250) evaluated in time by the counter unit.

2. Measured value acquisition arrangement (30) according to claim 1,
**characterized in that**
the control device (300) has at least one of the following components:

- a reference unit (31), which is connected to the storage arrangement (250), for generating a reference signal (rs), in particular a reference voltage,
- a comparison unit (33) for comparing an evaluation signal (as), in particular an electrical evaluation voltage, with a reference signal (rs), in particular the reference voltage, wherein preferably the evaluation signal (as) and/or the reference signal (rs) are/is specific for the respective charge state present after the charge transfer, in particular for an electrical voltage (S), of the storage arrangement (250),
- an initiation unit (34), which is connected to the storage arrangement (250), for generating an evaluation signal (as), in particular an electrical evaluation voltage, preferably as a result of a charging and/or discharging process of the storage arrangement (250), so that the evaluation signal (as), in particular the electrical evaluation voltage, changes over time during the comparison,
wherein preferably the counter unit (35) determines a time duration (td) as a function of the comparison,
- a processing device (36) for reading the time duration (td) from the counter unit (35) to perform the detection based on the time duration (td).

3. Measured value acquisition arrangement (30) according to claim 1 or 2,
**characterized in that**
the counter unit (35) is designed to detect a time duration (td) dependent on the charge state of the storage arrangement (250), in particular a discharge time duration or charge time duration of a storage capacitor (251) of the storage arrangement (250), in order to thereby evaluate the charge state of the storage arrangement (250) in terms of time, wherein, in particular, the detected time duration (td) correlates with the charge state of the storage arrangement (250) and/or with a sensor capacitance (CS) of the sensor element (20).

4. A measured value acquisition arrangement (30) according to any one of the preceding claims,
**characterized in that**
the counter unit (35) has a, preferably electronic, timer in order to carry out the time evaluation.

5. A measured value acquisition arrangement (30) according to any one of the preceding claims,
**characterized in that**
the storage arrangement (250) has at least one storage capacitor (251) in order to evaluate the charge state of the storage arrangement (250) over time as a charge state of the storage capacitor (251), in particular to determine it.

6. A measured value acquisition arrangement (30) according to any one of the preceding claims,
**characterized in that**
the control device (300) has a comparison unit (33) in the form of an electronic comparator (33) in order to measure the time duration (td) until a voltage of a storage capacitor (251) of the storage arrangement (250) reaches, preferably falls below or exceeds, a predetermined voltage threshold as reference voltage as evaluation voltage, the time duration (td) preferably being dependent on an electrical voltage of the storage capacitor (251).

7. A measured value acquisition arrangement (30) according to any one of the preceding claims,
**characterized in that**

the control device (300) has a reference unit (31) in order to estimate the charge state of the storage arrangement (250) for generating a reference signal, in particular a reference voltage, in particular coarse,
and/or **in that** the reference unit (31) has a digital-to-analog converter (32), which in particular has a resolution in the range from 2 bits to 10 bits, preferably 4 bits to 8 bits.

8. A measured value acquisition arrangement (30) according to any one of the preceding claims, **characterized in that** the control device (300) has an intermediate storage device (301) for storing a result of the temporal evaluation by the counter unit (35) and previous evaluations, in order to evaluate a temporal change in the charge state of the storage arrangement (250) and/or a sensor capacitance (CS) of the sensor element (20) for the detection.

9. A measured value acquisition arrangement (30) according to any one of the preceding claims, **characterized in that**

   the sensor element (20) is designed as a, preferably capacitive, sensor electrode (20) in order to provide the parameter specific to the detection as a variable sensor capacitance (CS) of the sensor element (20),
   wherein, in particular, the change in the sensor capacitance (CS) is specific to the change in the environment of the sensor element (20).

10. A measured value acquisition arrangement (30) according to any one of the preceding claims, **characterized in that**

    the control device (300) is designed for the electrical, preferably repetitive, actuation of the sensor element (20) in order to repeatedly charge and/or discharge the sensor element (20) as a function of a sensor capacitance (CS) of the sensor element (20),
    wherein in particular the control device (300) is designed to initiate the generation of a control signal, preferably with an at least approximate sinusoidal shape, for the electrical control of the sensor element (20), in order to initiate the charging and/or discharging,
    wherein the control device (300) is preferably designed to initiate a charge transfer to the storage arrangement (250) for detecting the activation action as a function of the charging and/or discharging of the sensor element and/or the electrical activation, so that the electrical charge stored by the storage arrangement (250) is specific to the change in the sensor capacitance (CS) of the sensor element (20).

11. System comprising:

    - a measured value acquisition arrangement (30) according to one of the preceding claims,
    - a control device (300) for outputting an activation signal in the event of detection of the activation action,
    - a control unit (8) which is in a signal connection with the measured value acquisition arrangement (30) in order to carry out an activation of an opening and/or unlocking of a flap (1.3, 1.6) on the vehicle (1) when the activation signal is received.

12. Method for a detection of an activation action for activating an opening and/or unlocking of a flap (1.3, 1.6) on the vehicle (1) by means of a measured value acquisition arrangement (30) according to one of the preceding claims, whereby the following steps are carried out:

    a) actuation of a control of at least one sensor element (20),
    b) carrying out a charge transfer to an electrical storage arrangement (250) as a function of the control,
    c) carrying out a temporal evaluation of a charge state of the storage arrangement (250) in order to determine a specific parameter of the sensor element (20) which is specific for a change, in particular an approach by an activation means (3), in an environment of the sensor element (20).

13. Method according to any one of the preceding claims, **characterized in that**

    the charge state of the storage arrangement (250) is detected during the time evaluation, in particular only by means of a time measurement, preferably without the use of analog-digital detection of an electrical voltage dependent on the state of charge of the storage arrangement (250) or only with a, preferably rough, estimate of the state of charge of the storage arrangement (250) using an analog-digital acquisition in order to provide a reference signal, in particular a reference voltage, which is cumulated with the state of charge of the storage arrangement (250) evaluated in time by the counter unit to form a measured value for the state of charge of the storage arrangement (250) and/or the specific parameter, in particular the sensor capacitance (CS), of the sensor element (20).

14. Method according to any one of the preceding claims, **characterized in that** the temporal evaluation comprises an evaluation of a time-dependent property of the storage arrangement (250), preferably an evaluation of a charging and/or discharging time of the storage arrangement (250).

## Revendications

**1.** Dispositif d'acquisition de valeurs de mesure (30) pour un véhicule (1) pour la détection d'une action d'activation pour une activation, en particulier une ouverture et/ou un déverrouillage, d'un volet (1.3, 1.6) sur le véhicule (1), présentant :

> - au moins un élément de détection (20) pour détecter un changement, en particulier une approche par un moyen d'activation (3), dans un environnement de l'élément de détection (20),
> - un dispositif de contrôle (300) pour déterminer au moins un paramètre de l'élément de détection (20) spécifique à la détection, afin d'effectuer la détection de l'action d'activation,
> - un dispositif de stockage électrique (250) qui est connecté à l'au moins un élément de détection (20) pour le transfert de charge, où le transfert de charge est spécifique au paramètre de l'élément de détection (20),
>
> le dispositif de contrôle (300) présentant une unité de comptage (35) qui est connectée au dispositif de stockage (250) afin d'évaluer dans le temps un état de charge du dispositif de stockage (250),
> **caractérisé en ce qu'**
> une unité de référence (31) est adaptée pour fournir un signal de référence à un dispositif de traitement (36),
> le dispositif de traitement (36) formant, à partir du signal de référence fourni par l'unité de référence (31) et de l'état de charge du dispositif de stockage (250) évalué dans le temps par l'unité de comptage, une valeur de mesure pour l'état de charge du dispositif de stockage (250) et/ou le paramètre spécifique de l'élément de détection (20).

**2.** Dispositif d'acquisition de valeurs de mesure (30) selon la revendication 1,
**caractérisé en ce que**
le dispositif de contrôle (300) présente au moins l'un des composants suivants :

> - une unité de référence (31), qui est connectée au dispositif de stockage (250), pour générer un signal de référence (rs), en particulier une tension de référence,
> - une unité de comparaison (33) pour comparer un signal d'évaluation (as), notamment une tension électrique d'évaluation, à un signal de référence (rs), notamment à la tension de référence, le signal d'évaluation (as) et/ou le signal de référence (rs) étant de préférence spécifiques à l'état de charge présent respectivement après le transfert de charge, notamment à une tension électrique (S), du dispositif de stockage (250),

> - une unité d'initiation (34), qui est connectée au dispositif de stockage (250), pour générer un signal d'évaluation (as), notamment une tension électrique d'évaluation, de préférence à la suite d'une opération de charge et/ou de décharge du dispositif de stockage (250), de sorte que le signal d'évaluation (as), notamment la tension électrique d'évaluation, varie dans le temps pendant la comparaison,
> de préférence, l'unité de comptage (35) détermine une durée (td) en fonction de la comparaison,
> - un dispositif de traitement (36) pour lire la durée (td) à partir de l'unité de comptage (35) afin d'effectuer la détection sur la base de la durée (td).

**3.** Dispositif d'acquisition de valeurs de mesure (30) selon la revendication 1 ou 2,
**caractérisé en ce que**

> l'unité de comptage (35) est réalisée pour détecter une durée (td) dépendant de l'état de charge du dispositif de stockage (250), en particulier une durée de décharge ou une durée de charge d'un condensateur de stockage (251) du dispositif de stockage (250), afin d'évaluer ainsi dans le temps l'état de charge du dispositif de stockage (250),
> dans lequel, en particulier, la durée (td) détectée est en corrélation avec l'état de charge du dispositif de stockage (250) et/ou avec une capacité de capteur (CS) de l'élément de détection (20).

**4.** Dispositif d'acquisition de valeurs de mesure (30) selon l'une quelconque des revendications précédentes,
**caractérisé en ce que**
l'unité de comptage (35) présente une minuterie, de préférence électronique, pour effectuer l'évaluation temporelle.

**5.** Dispositif d'acquisition de valeurs de mesure (30) selon l'une quelconque des revendications précédentes,
**caractérisé en ce que**
le dispositif de stockage (250) présente au moins un condensateur de stockage (251), afin d'évaluer, en particulier de déterminer, l'état de charge du dispositif de stockage (250) en tant qu'état de charge du condensateur de stockage (251) dans le temps.

**6.** Dispositif d'acquisition de valeurs de mesure (30) selon l'une quelconque des revendications précédentes,
**caractérisé en ce que**
le dispositif de contrôle (300) présente une unité de comparaison (33) sous la forme d'un comparateur électronique (33) pour mesurer la durée (td) jusqu'à ce qu'une tension d'un condensateur de stockage (251) du dispositif de stockage (250) atteigne, comme tension d'évaluation, un seuil de tension prédéfini comme tension de référence, de préférence en dessous ou au-dessus de celui-ci, la durée (td) dépendant de préférence d'une tension électrique du condensateur de stockage (251).

7. Dispositif d'acquisition de valeurs de mesure (30) selon l'une quelconque des revendications précédentes,
   **caractérisé en ce que**

   le dispositif de contrôle (300) comporte une unité de référence (31) pour estimer l'état de charge du dispositif de stockage (250) pour générer un signal de référence, en particulier une tension de référence, notamment grossière,
   et/ou **en ce que** l'unité de référence (31) présente un convertisseur numérique-analogique (32), qui présente en particulier une résolution dans la plage de 2 bits à 10 bits, de préférence de 4 bits à 8 bits.

8. Dispositif d'acquisition de valeurs de mesure (30) selon l'une quelconque des revendications précédentes,
   **caractérisé en ce que**
   le dispositif de contrôle (300) présente un dispositif de stockage intermédiaire (301) pour le stockage d'un résultat de l'évaluation temporelle par l'unité de comptage (35) et d'évaluations précédentes, afin d'évaluer une modification temporelle de l'état de charge du dispositif de stockage (250) et/ou d'une capacité de capteur (CS) de l'élément de détection (20) pour la détection.

9. Dispositif d'acquisition de valeurs de mesure (30) selon l'une quelconque des revendications précédentes,
   **caractérisé en ce que**
   l'élément de détection (20) est réalisé sous la forme d'une électrode de capteur (20), de préférence capacitive, pour mettre à disposition le paramètre spécifique à la détection sous la forme d'une capacité de capteur (CS) variable de l'élément de détection (20), dans lequel, en particulier, la variation de la capacité du capteur (CS) est spécifique à la variation dans l'environnement de l'élément de détection (20).

10. Dispositif d'acquisition de valeurs de mesure (30) selon l'une quelconque des revendications précédentes,
    **caractérisé en ce que**

    le dispositif de contrôle (300) est réalisé pour la commande électrique, de préférence répétée, de l'élément de détection (20), afin de charger et/ou de décharger de manière répétée l'élément de détection (20) en fonction d'une capacité de détection (CS) de l'élément de détection (20),
    le dispositif de contrôle (300) étant notamment conçu pour initier, en vue de la commande électrique de l'élément de détection (20), une génération d'un signal de commande, ayant de préférence une forme au moins approximativement sinusoïdale, afin d'initier la charge et/ou la décharge,
    dans lequel, de préférence, le dispositif de contrôle (300) est conçu pour initier un transfert de charge vers le dispositif de stockage (250) pour détecter l'action d'activation en fonction de la charge et/ou de la décharge de l'élément de détection et/ou de la commande électrique, de sorte que la charge électrique stockée par le dispositif de stockage (250) est spécifique à la variation de la capacité de détection (CS) de l'élément de détection (20).

11. Système comprenant:

    - un dispositif d'acquisition de valeurs de mesure (30) selon l'une des revendications précédentes,
    - un dispositif de contrôle (300) pour émettre un signal d'activation en cas de détection de l'action d'activation,
    - un appareil de commande (8) qui est en liaison de signalisation avec le dispositif d'acquisition de valeurs de mesure (30), afin d'exécuter une activation d'une ouverture et/ou d'un déverrouillage d'un volet (1.3, 1.6) sur le véhicule (1) lors de la réception du signal d'activation.

12. Procédé pour une détection d'une action d'activation pour activer une ouverture et/ou un déverrouillage d'un volet (1.3, 1.6) sur le véhicule (1) à l'aide d'un dispositif d'acquisition de valeurs de mesure (30) selon l'une des revendications précédentes,
    où les étapes suivantes sont effectuer :

    a) effectuer une commande d'au moins un élément de détection (20),
    b) effectuer un transfert de charge vers un dispositif de stockage électrique (250) en fonction de la commande,
    c) effectuer une évaluation temporelle d'un état de charge du dispositif de stockage (250), afin de déterminer un paramètre spécifique de l'élément de détection (20), qui est spécifique à une modification, en particulier une approche par un moyen d'activation (3), dans un environnement de l'élément de détection (20).

**13.** Procédé selon l'une quelconque des revendications précédentes,
**caractérisé en ce que,**

lors de l'évaluation temporelle, l'état de charge du dispositif de stockage (250) est saisi, en particulier uniquement, à l'aide d'une mesure du temps,

de préférence sans l'utilisation d'une détection analogique-numérique d'une tension électrique dépendant de l'état de charge du dispositif de stockage (250) ou

soit seulement avec une estimation, de préférence approximative, de l'état de charge du dispositif de stockage (250) à l'aide d'une détection analogique-numérique, afin de fournir un signal de référence, en particulier une tension de référence, qui est cumulé avec l'état de charge du dispositif de stockage (250) évalué dans le temps par l'unité de comptage pour donner une valeur de mesure pour l'état de charge du dispositif de stockage (250) et/ou le paramètre spécifique, en particulier la capacité de capteur (CS), de l'élément de détection (20).

**14.** Procédé selon l'une quelconque des revendications précédentes,
**caractérisé en ce que**
l'évaluation temporelle comprend une évaluation d'une propriété dépendant du temps du dispositif de stockage (250), de préférence une évaluation d'un temps de charge et/ou de décharge du dispositif de stockage (250).

**Fig. 1**

**Fig. 2**

Fig. 3

**Fig. 4**

**Fig. 5**

**Fig. 6**

```
┌─────────────────────────────────┐
│              501                │
└─────────────────────────────────┘
                 ⇓
┌─────────────────────────────────┐
│              502                │
└─────────────────────────────────┘
                 ⇓
┌─────────────────────────────────┐
│              503                │
└─────────────────────────────────┘
```

# Fig. 7

Fig. 8

**Fig. 9**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9587964 B2